# EUROPEAN PATENT APPLICATION

(11) **EP 4 447 638 A1**
(43) Date of publication of application: **16.10.2024**
(21) Application number: 24166620.5
(22) Date of filing: 27.03.2024
(51) Int. Cl.: H10K 59/121, H10K 59/80

(54) **DISPLAY DEVICE AND METHOD FOR MANUFACTURING THE SAME**

(30) Priority: 10.04.2023 KR 20230046676
(71) Applicant: Samsung Display Co., Ltd., Yongin-si, Gyeonggi-do 17113 (KR)
(72) Inventor: Seo, Yeon Ju, 17113 Giheung-gu, Yongin-si (KR); KI, Won Jang, 17113 Giheung-gu, Yongin-si (KR); KIM, Nam Jin, 17113 Giheung-gu, Yongin-si (KR); Choi, Deok Young, 17113 Giheung-gu, Yongin-si (KR)
(74) Representative: Dr. Weitzel & Partner

(57) **Abstract**

A display device includes: a substrate including a display area, a non-display area, and a sub-region, a circuit layer, a light emitting element layer, an encapsulation layer, and a polarization layer. The non-display area includes a dam area apart from the display area and in which at least one dam portion surrounding the display area is arranged, and a junction area surrounding the dam area. The circuit layer includes a semiconductor layer, a first insulating layer, a first conductive layer, a second insulating layer, a second conductive layer, a third insulating layer, a third conductive layer, a fourth insulating layer, and a fourth conductive layer. In the junction area, the encapsulation layer is disposed on the third insulating layer. A thickness of the third insulating layer at a central point of the junction area is substantially the same as a thickness of the third insulating layer in the display area.

## Description

### BACKGROUND

### 1. Technical Field

The present invention relates to a display device and a method for manufacturing the same.

### 2. Description of the Related Art

With the advance of information-oriented society, more and more demands are placed on a display device for displaying images in various ways. For example, the display device is employed in various electronic devices such as smartphones, digital cameras, laptop computers, navigation devices, and smart televisions.

The display device may be a flat panel display device such as a liquid crystal display device, a field emission display device and a light emitting display device. Examples of the light emitting display device may include an organic light emitting display device including organic light emitting elements, an inorganic light emitting display device including inorganic light emitting elements such as inorganic semiconductors, and a micro light emitting display device including micro light emitting elements.

The organic light emitting display device displays an image using light emitting elements, each including a light emitting layer made of an organic light emitting material. As described above, the organic light emitting display device implements image display using a self-light emitting element, and thus may have relatively superior performance in power consumption, response speed, luminous efficiency, luminance, and wide viewing angle compared to other display devices.

One surface of the display device may include a display area in which an image is displayed and a non-display area that is a periphery of the display area. Emission areas emitting light with respective luminances and colors may be arranged in the display area.

That is, the display device may include a substrate including a display area and a non-display area, a circuit layer including pixel drivers disposed on the substrate and respectively corresponding to the emission areas, a light emitting element layer including light emitting elements disposed on the circuit layer and respectively corresponding to the emission areas, and an encapsulation layer disposed on the light emitting element layer. The encapsulation layer may be bonded to the inorganic insulating material of the circuit layer in the non-display area to encapsulate the light emitting element layer. Permeation of oxygen or moisture is blocked by such an encapsulation layer, and rapid deterioration of the organic light emitting material and the like of the light emitting element layer may be prevented.

The circuit layer may include conductive layers for preparing pixel drivers and lines electrically connected to the pixel drivers, and insulating layers disposed between the conductive layers. As the conductive layers of the circuit layer are made of a metal material, some of the insulating layers of the circuit layer adjacent to the substrate may include an inorganic insulating material. Further, in consideration of the uniformity of the direction in which the light emitting elements of the light emitting element layer emit light, some of the insulating layers of the circuit layer adjacent to the light emitting element layer may include an organic insulating material having a relatively thick thickness.

### SUMMARY

Since the organic insulating material may serve as a permeation path for oxygen or moisture, the organic insulating material may not be disposed in an area (hereinafter, referred to as a "junction area") in which the circuit layer and the encapsulation layer are bonded in the non-display area.

That is, unlike the case where the inorganic insulating material of the circuit layer is covered with the organic insulating material in the display area, the thickness of the inorganic insulating material in the junction area may be different from the thickness in the display area because the inorganic insulating material is exposed in the junction area due to removal of the organic insulating material. As a result, in the junction area, the conductive layer may be damaged by corrosion, cracking, oxidation, and the like.

In particular, when a polarization layer extends to the non-display area to be more stably disposed, the thinned inorganic insulating material of the junction area may be easily damaged due to the pressure of the laminating process for disposing the polarization layer. Accordingly, since a defect such as the disconnection or oxidation of a line disposed in the junction area may be caused, quality reliability and lifespan of the display device may be deteriorated.

Accordingly, aspects of the present invention provide a display device capable of reducing damage to an inorganic insulating material in a junction area to improve quality reliability and lifespan, and a method for manufacturing the same. Embodiments of the invention are described by the features of the independent claims. The dependent claims describe preferred embodiments.

According to an embodiment of the present invention as described in claim 1, there is provided a display device including: a substrate including a main region including a display area in which emission areas are arranged and a non-display area disposed around the display area, and a sub-region protruding from one side of the main region; a circuit layer disposed on the substrate; a light emitting element layer disposed on the circuit layer; an encapsulation layer disposed on the light emitting element layer; and a polarization layer disposed on the encapsulation layer and overlapping the light emitting element layer. The non-display area includes: a dam area spaced apart from the display area and in which at least one dam portion surrounding the display area is arranged; and a junction area surrounding the dam area. The circuit layer includes: a semiconductor layer disposed on the substrate; a first insulating layer disposed on the substrate, covering the semiconductor layer, and containing an inorganic insulating material; a first conductive layer disposed on the first insulating layer; a second insulating layer disposed on the first insulating layer, covering the first conductive layer, and containing the inorganic insulating material; a second conductive layer disposed on the second insulating layer; a third insulating layer disposed on the second conductive layer, covering the second conductive layer, and containing the inorganic insulating material; a third conductive layer disposed on the third insulating layer; a fourth insulating layer disposed on the third insulating layer, covering the third conductive layer, and containing an organic insulating material; a fourth conductive layer disposed on the fourth insulating layer; and a fifth insulating layer disposed on the fourth insulating layer, covering the fourth conductive layer, and containing the organic insulating material. In the junction area, the encapsulation layer is disposed directly on the third insulating layer. A thickness of the third insulating layer at a central point of the junction area is substantially the same as a thickness of the third insulating layer in the display area, and the central point is measured with respect to a direction from the sub-region to the main region.

The polarization layer may extend to the non-display area and overlaps the junction area of the non-display area.

The sub-region may include a bending area which is bendable; a first sub-region disposed between one side of the bending area and the main region; and a second sub-region connected to the other side of the bending area. The light emitting element layer may include light emitting elements corresponding to the emission areas, respectively. The circuit layer may further include: pixel drivers corresponding to the emission areas and electrically connected to the light emitting elements of the light emitting element layer, respectively; data lines for transmitting a data signal to the pixel drivers; and data connection lines disposed in the non-display area, electrically connected to the data lines, respectively, and extending to the first sub-region. The fourth conductive layer may include the data lines. The first conductive layer may include some of the data connection lines. The second conductive layer may include remaining others of the data connection lines. The polarization layer may overlap the data connection lines in the non-display area.

Each of the pixel drivers may include two or more transistors and at least one capacitor. The semiconductor layer may include active layers of the transistors. The first conductive layer may further include gate electrodes of the transistors. The second conductive layer may further include a first capacitor electrode of the capacitor. The third conductive layer may include source electrodes of the transistors and drain electrodes of the transistors. The fourth conductive layer may further include anode connection electrodes corresponding to the emission areas, respectively.

The encapsulation layer may include: a first encapsulation layer disposed in the main region, covering the light emitting element layer and the at least one dam portion, and containing the inorganic insulating material; a second encapsulation layer disposed on the first encapsulation layer, overlapping the light emitting element layer, and containing the organic insulating material; and a third encapsulation layer covering the second encapsulation layer and containing the inorganic insulating material. The second encapsulation layer may be disposed in an area surrounded by the at least one dam portion in the main region. The first encapsulation layer may be in contact with the third insulating layer in the junction area. The third encapsulation layer may be in contact with the first encapsulation layer in the junction area.

The light emitting element layer may include: anode electrodes disposed on the fifth insulating layer of the circuit layer and corresponding to the emission areas, respectively; a pixel defining layer disposed on the fifth insulating layer of the circuit layer, corresponding to a non-emission area which is a separation area between the emission areas, and covering an edge of each of the anode electrodes; a spacer layer disposed on a part of the pixel defining layer; first common layers disposed on the anode electrodes, respectively; light emitting layers disposed on the first common layers, respectively; a second common layer disposed on the pixel defining layer, the spacer layer, and the light emitting layers; and a cathode electrode disposed on the second common layer. Each of the light emitting elements may include a structure in which a corresponding first common layer, a corresponding light emitting layer, and a corresponding second common layer are disposed between the anode electrode and the cathode electrode facing each other.

The display device may further include: data bending lines disposed in the bending area, electrically connected to the data connection lines, respectively, and extending to the second sub-region; a bending hole defined in the bending area and penetrating the first insulating layer, the second insulating layer, and the third insulating layer; and a bank covering the bending hole and extending to the first sub-region. The bank may include: a first bank layer which is a part of the fourth insulating layer and covers the bending hole; a second bank layer which is a part of the fifth insulating layer and covers the first bank layer; a third bank layer which is the same layer as the pixel defining layer and disposed on the second bank layer; and a fourth bank layer which is the same layer as the spacer layer and disposed on the third bank layer. The fourth conductive layer may further include the data bending lines. The data bending lines may be disposed on the first bank layer and covered with the second bank layer. Each of the at least one dam portion may include a structure in which two or more dam layers are stacked. Each of the two or more dam layers may be the same layer as any one of the fourth insulating layer, the fifth insulating layer, the pixel defining layer, and the spacer layer. The polarization layer may extend to the first sub-region and overlaps a part of the bank.

The display device may define a through portion therein corresponding to a hole area surrounded by the main region and penetrating the substrate, the circuit layer, the light emitting element layer, the encapsulation layer, and the polarization layer. A hole periphery area between the hole area and the main region may include: a hole periphery encapsulation area disposed around the hole area; a hole periphery dam area disposed around the hole periphery encapsulation area, and a hole periphery bypass area disposed between the hole periphery dam area and the main region. The display device may further include: at least one auxiliary dam portion disposed on the third insulating layer in the hole periphery dam area and surrounding a periphery of the hole periphery encapsulation area; a hole periphery etching stop layer disposed on the second insulating layer in the hole periphery encapsulation area and covered with the third insulating layer; one or more first opening grooves defined in the hole periphery encapsulation area, penetrating the third insulating layer, and sequentially surrounding a periphery of the hole area; two or more groove guides disposed on the fourth insulating layer in the hole periphery encapsulation area and overlapping peripheral areas of the one or more first opening grooves, respectively; and one or more encapsulation auxiliary grooves defined between the two or more groove guides and penetrating the fourth insulating layer and the fifth insulating layer. Each of the one or more encapsulation auxiliary grooves may include: a first auxiliary groove penetrating the fifth insulating layer; a second auxiliary groove penetrating the fourth insulating layer; and an undercut structure in which edges of the two or more groove guides protrude beyond edges of the second auxiliary grooves of the one or more encapsulation auxiliary grooves. The second common layer and the cathode electrode may each be discontinuous by the undercut structure of each of the one or more encapsulation auxiliary grooves.

According to an embodiment of the present invention as described in claim 9, a method for manufacturing a display device includes: providing a substrate including a main region including a display area in which emission areas are arranged and a non-display area disposed around the display area, and a sub-region protruding from one side of the main region; and disposing a circuit layer including pixel drivers corresponding to the emission areas, respectively, on the substrate. The disposing of the circuit layer includes: disposing a semiconductor layer on the substrate; disposing a first insulating layer covering the semiconductor layer on the substrate; disposing a first conductive layer on the first insulating layer; disposing a second insulating layer covering the first conductive layer on the first insulating layer; disposing a second conductive layer on the second insulating layer; disposing a third insulating layer covering the second conductive layer on the second insulating layer; disposing a third conductive layer on the third insulating layer; disposing a fourth insulating layer covering the third conductive layer on the third insulating layer; disposing a fourth conductive layer on the fourth insulating layer; and disposing a fifth insulating layer covering the fourth conductive layer on the fourth insulating layer. The non-display area includes: a dam area spaced apart from the display area and in which at least one dam portion surrounding the display area is arranged, and a junction area surrounding the dam area. in the disposing of the fourth insulating layer, the fourth insulating layer includes: a first planarization layer disposed in the display area, and a temporary protective layer disposed in at least a part of the junction area and spaced apart from the dam area and the sub-region. in the disposing of the fifth insulating layer, the fifth insulating layer includes: a second planarization layer covering the first planarization layer, and the disposing of the circuit layer further includes removing the temporary protective layer after the disposing of the fourth conductive layer.

The removing of the temporary protective layer may be performed before the disposing of the fifth insulating layer.

The removing of the temporary protective layer may be performed after the disposing of the fifth insulating layer.

The sub-region may include: a bending area which is bendable; a first sub-region disposed between one side of the bending area and the main region; and a second sub-region connected to the other side of the bending area. The disposing of the circuit layer may further include, before the disposing of the third conductive layer, forming a bending hole corresponding to the bending area and penetrating the first insulating layer, the second insulating layer, and the third insulating layer.

The method may further include: disposing a light emitting element layer on the circuit layer, disposing an encapsulation layer on the light emitting element layer, disposing a touch sensor layer on the encapsulation layer, and disposing a polarization layer overlapping the light emitting element layer on the touch sensor layer. In the disposing of the light emitting element layer, the light emitting element layer may include: anode electrodes disposed on the fifth insulating layer of the circuit layer and corresponding to the emission areas, respectively; a pixel defining layer disposed on the fifth insulating layer of the circuit layer, corresponding to a non-emission area which is a separation area between the emission areas, and covering an edge of each of the anode electrodes; first common layers disposed on the anode electrodes, respectively; light emitting layers disposed on the first common layers, respectively; a second common layer disposed on the pixel defining layer and the light emitting layers; and a cathode electrode disposed on the second common layer. Each of the light emitting elements may include a structure in which a corresponding first common layer, a corresponding light emitting layer, and a corresponding second common layer are disposed between the anode electrode and the cathode electrode facing each other.

The circuit layer may include: data lines for transmitting a data signal to the pixel drivers; and data connection lines disposed in the non-display area, electrically connected to the data lines, respectively, and extending to the first sub-region. Each of the pixel drivers of the circuit layer may include: two or more transistors and at least one capacitor. In the disposing of the semiconductor layer, the semiconductor layer may include: active layers of the transistors. In the disposing of the first conductive layer, the first conductive layer may further include: gate electrodes of the transistors, and some of the data connection lines. In the disposing of the second conductive layer, the second conductive layer may further include: a first capacitor electrode of the capacitor, and remaining others of the data connection lines. In the disposing of the third conductive layer, the third conductive layer may include source electrodes of the transistors and drain electrodes of the transistors. In the disposing of the fourth conductive layer, the fourth conductive layer may further include anode connection electrodes corresponding to the emission areas, respectively.

In the disposing of the fourth insulating layer, the temporary protective layer may overlap a part of the data connection lines.

In the disposing of the encapsulation layer, the encapsulation layer may include: a first encapsulation layer disposed in the main region, covering the light emitting element layer and the at least one dam portion, and containing the inorganic insulating material, a second encapsulation layer disposed on the first encapsulation layer, overlapping the light emitting element layer, and containing the organic insulating material, and a third encapsulation layer covering the second encapsulation layer and containing the inorganic insulating material. The second encapsulation layer may be disposed in an area surrounded by the at least one dam portion in the main region. The first encapsulation layer may be in contact with the third insulating layer in the junction area. The third encapsulation layer may be in contact with the first encapsulation layer in the junction area.

In the disposing of the polarization layer, the polarization layer may extend to the non-display area and further overlaps the data connection lines of the non-display area.

In the disposing of the fourth insulating layer, the fourth insulating layer may further include: a first bank layer covering the bending hole of the bending area, extending to the first sub-region, and spaced apart from the temporary protective layer. In the disposing of the fourth conductive layer, the fourth conductive layer may further include: data bending lines disposed in the bending area, electrically connected to the data connection lines, respectively, and extending to the second sub-region. In the disposing of the fifth insulating layer, the fifth insulating layer may further include: a second bank layer covering the first bank layer and the data bending lines. In the disposing of the light emitting element layer, a third bank layer which is the same layer as the pixel defining layer and disposed on the second bank layer, and a fourth bank layer which is the same layer as the spacer layer and disposed on the third bank layer may be provided.

Each of the at least one dam portion may include: a structure in which two or more dam layers are stacked. Each of the two or more dam layers may be the same layer as any one of the fourth insulating layer, the fifth insulating layer, the pixel defining layer, and the spacer layer.

In the providing of the substrate, the substrate further may include: a hole area surrounded by the main region, and a hole periphery area disposed between the main region and the hole area. The method may further include: after the disposing of the polarization layer, forming a through portion corresponding to the hole area, and penetrating the substrate, the circuit layer, the light emitting element layer, the encapsulation layer, and the polarization layer.

The hole periphery area may include: a hole periphery encapsulation area disposed around the hole area; a hole periphery dam area disposed around the hole periphery encapsulation area; and a hole periphery bypass area disposed between the hole periphery dam area and the main region. The pixel defining layer and the spacer layer may be spaced apart from the hole periphery bypass area. In the hole periphery dam area, at least one auxiliary dam portion surrounding a periphery of the hole periphery encapsulation area may be disposed on the third insulating layer. In the hole periphery encapsulation area, one or more encapsulation auxiliary grooves surrounding a periphery of the hole area and penetrating the fourth insulating layer and the fifth insulating layer may be arranged.

The disposing of the circuit layer may further include: before the disposing of the third insulating layer, disposing a hole periphery etching stop layer on the second insulating layer in the hole periphery encapsulation area, and after the disposing of the third insulating layer, forming one or more first opening grooves corresponding to the hole periphery encapsulation area, sequentially surrounding a periphery of the hole area, and penetrating the third insulating layer. In the disposing of the fourth conductive layer, the fourth conductive layer further includes two or more groove guides disposed in the hole periphery encapsulation area and overlapping peripheral areas of the one or more first opening grooves, respectively. The method may further include after the disposing of the fifth insulating layer: forming one or more second opening grooves overlapping the one or more first opening grooves, respectively, and penetrating the fifth insulating layer; disposing a mask layer defining openings corresponding to the one or more second opening grooves and the temporary protective layer, respectively, on the fifth insulating layer; and forming the one or more encapsulation auxiliary grooves, and removing the temporary protective layer by partially etching the fourth insulating layer and the fifth insulating layer using the two or more groove guides and the mask layer as masks.

In the disposing of the encapsulation auxiliary grooves, each of the encapsulation auxiliary grooves may include: a first auxiliary groove penetrating the fifth insulating layer, a second auxiliary groove penetrating the fourth insulating layer, and an undercut structure in which edges of the two or more groove guides protrude beyond edges of the second auxiliary grooves of the one or more encapsulation auxiliary grooves. In the disposing of the light emitting element layer, the second common layer and the cathode electrode may each be discontinuous by the undercut structure of each of the one or more encapsulation auxiliary grooves.

A display device according to one embodiment includes a substrate, a circuit layer on the substrate, a light emitting element layer on the circuit layer, an encapsulation layer on the light emitting element layer, and a polarization layer on the encapsulation layer.

The substrate includes a main region and a sub-region protruding from one side of the main region. The main region includes a display area in which emission areas are arranged, and a non-display area disposed around the display area. The non-display area includes a dam area spaced apart from the display area and in which at least one dam portion surrounding the display area is arranged, and a junction area surrounding the dam area.

The circuit layer includes a semiconductor layer on the substrate, a first insulating layer covering the semiconductor layer, a first conductive layer on the first insulating layer, a second insulating layer covering the first conductive layer, a second conductive layer on the second insulating layer, a third insulating layer covering the second conductive layer, a third conductive layer on the third insulating layer, a fourth insulating layer covering the third conductive layer, a fourth conductive layer on the fourth insulating layer, and a fifth insulating layer covering the fourth conductive layer. Each of the first insulating layer, the second insulating layer, and the third insulating layer contains an inorganic insulating material, and each of the fourth insulating layer and the fifth insulating layer contains an organic insulating material.

In the junction area, the encapsulation layer is disposed on the third insulating layer.

Further, according to one embodiment, a thickness of the third insulating layer at a central point of the junction area is the substantially the same as the thickness of the third insulating layer in the display area, and the central point is measured with respect to a direction from the sub-region to the main region.

That is, according to one embodiment, since the third insulating layer in the junction area in contact with the encapsulation layer has a thickness substantially the same as a thickness in the display area, it is possible to effectively prevent defects such as corrosion, cracking, and oxidation in the first conductive layer and the second conductive layer through the thinned third insulating layer in the junction area.

In addition, although the polarization layer extends into the non-display area and overlaps the junction area, defects in which the third insulating layer, the first conductive layer, and the second conductive layer are damaged in the junction area may be reduced during the disposing process of the polarization layer. Accordingly, quality reliability and lifespan of the display device may be effectively improved.

In addition, a method for manufacturing a display device according to embodiments includes preparing a substrate and disposing a circuit layer. The step of disposing the circuit layer includes disposing a semiconductor layer, disposing a first insulating layer, disposing a first conductive layer, disposing a second insulating layer, disposing a second conductive layer, disposing a third insulating layer, disposing a third conductive layer, disposing a fourth insulating layer, disposing a fourth conductive layer, and disposing a fifth insulating layer. In the step of disposing the fourth insulating layer, the fourth insulating layer includes a first planarization layer disposed in the display area, and a temporary protective layer disposed in at least a part of the junction area and spaced apart from the dam area and the sub-region. Further, the step of disposing the circuit layer further includes removing the temporary protective layer after disposing of the fourth conductive layer.

That is, according to embodiments, the fourth conductive layer is disposed after the fourth insulating layer including the temporary protective layer of the junction area is disposed. Accordingly, while the disposition of the fourth conductive layer is performed, the third insulating layer in the junction area is covered with the temporary protective layer, and thus may not be entirely exposed to an etching member to dispose the fourth conductive layer. Accordingly, the thickness of the third insulating layer in the junction area may be maintained substantially the same as the thickness of the third insulating layer in the display area.

In addition, according to one embodiment, the display device may further include a through portion corresponding to a hole area surrounded by the main region. The through portion may penetrate the substrate, the circuit layer, the light emitting element layer, and the polarization layer. In this case, the substrate may further include a hole area surrounded by the main region, and a hole periphery area disposed between the hole area and the main region. The hole periphery area may include a hole periphery encapsulation area disposed around the hole area, a hole periphery dam area disposed around the hole periphery encapsulation area, and a hole periphery bypass area disposed between the hole periphery dam area and the main region. In the hole periphery encapsulation area, at least one of the auxiliary encapsulation grooves that surround the periphery of the hole area and penetrate the fourth insulating layer and the fifth insulating layer may be arranged.

According to one embodiment, the step of removing the temporary protective layer may be performed together with the process of disposing the encapsulation auxiliary grooves. In this way, since a separate process for removing the temporary protective layer is not added, the manufacturing process of the display device may be prevented from becoming complicated due to the temporary protective layer.

The effects of the present invention are not limited to the aforementioned effects, and various other effects are included in the present specification.

### BRIEF DESCRIPTION OF THE DRAWINGS

The above and other aspects and features of the present invention will become more apparent by describing in detail exemplary embodiments thereof with reference to the attached drawings, in which:
FIG. 1 is a perspective view illustrating a display device according to one embodiment;
FIG. 2 is a plan view illustrating the display device of FIG. 1;
FIG. 3 is a cross-sectional view taken along line A-A' of FIG. 2;
FIG. 4 is a plan view illustrating the main region and the sub-region of the display device of FIG. 1 according to an embodiment;
FIG. 5 is a layout diagram illustrating part B of FIG. 4;
FIG. 6 is an equivalent circuit diagram illustrating one pixel driver corresponding to one emission area among the pixel drivers included in the circuit layer of FIG. 3;
FIG. 7 is a plan view illustrating the touch sensor layer of FIG. 3;
FIG. 8 is an enlarged view showing part D of FIG. 7;
FIG. 9 is a cross-sectional view taken along line E-E' of FIG. 8;
FIG. 10 is a layout diagram illustrating part C of FIG. 4;
FIG. 11 is a cross-sectional view taken along line F-F' of FIG. 10;
FIG. 12 is a flowchart illustrating a method for manufacturing the display device according to the embodiment of FIG. 4;
FIG. 13 is a flowchart illustrating the steps of disposing the circuit layers of FIG. 12;
FIGS. 14, 15, 16, 17, 18, 19, 20, 21, 22, 23, 24, 25, and 26 are process diagrams illustrating some steps of FIGS. 12 and 13;
FIG. 27 is a plan view illustrating a main region and a sub-region of a display device according to another embodiment;
FIG. 28 is a layout diagram illustrating part G of FIG. 27;
FIG. 29 is a cross-sectional view taken along line H-H' of FIG. 28;
FIG. 30 is a flowchart showing steps of disposing the circuit layer of FIG. 12 according to the embodiment of FIG. 27; and
FIGS. 31, 32, 33, 34, 35, 36, 37, 38, 39, and 40 are process views illustrating some steps of FIGS. 12 and 30.

### DETAILED DESCRIPTION

Embodiments of the present invention will now be described more fully hereinafter with reference to the accompanying drawings. The embodiments may, however, be provided in different forms and should not be construed as limiting. The same reference numbers indicate the same components throughout the present disclosure. In the accompanying figures, the thickness of layers and regions may be exaggerated for clarity.

Some of the parts that are not associated with the description may not be provided in order to describe embodiments of the present invention.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and/or vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner.

The terms "about" or "substantially the same" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, " substantially the same " may mean within one or more standard deviations, or within ± 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which the present invention pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments will be described with reference to the accompanying drawings.

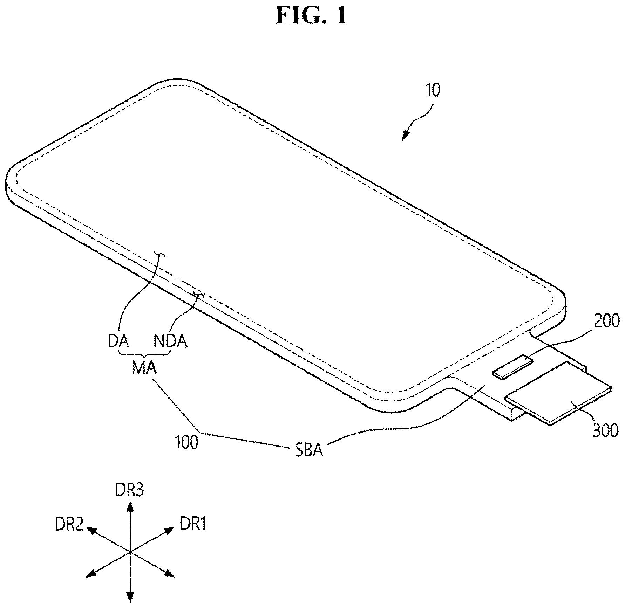

FIG. 1 is a perspective view illustrating a display device according to one embodiment.

Referring to FIG. 1, a display device 10 is a device for displaying a moving image or a still image. The display device 10 may be used as a display screen of various devices, such as a television, a laptop computer, a monitor, a billboard and an Internet-of-Things ("IOT") device, as well as portable electronic devices such as a mobile phone, a smartphone, a tablet personal computer ("PC"), a smart watch, a watch phone, a mobile communication terminal, an electronic notebook, an electronic book, a portable multimedia player ("PMP"), a navigation device and an ultra-mobile PC ("UMPC").

The display device 10 may be a light emitting display device such as an organic light emitting display using an organic light emitting diode, a quantum dot light emitting display including a quantum dot light emitting layer, an inorganic light emitting display including an inorganic semiconductor, and a micro light emitting display using a micro or nano light emitting diode ("LED"). Hereinafter, a case in which the display device 10 is an organic light emitting display device will be mainly described, but the present invention may be applied to a display device including an organic insulating material, an organic light emitting material, and a metal material.

The display device 10 may be formed to be flat, but is not limited thereto. For another example, the display device 10 may include a curved portion formed at left and right ends and having a constant curvature or a varying curvature. In addition, the display device 10 may be formed flexibly so that it can be curved, bent, folded, or rolled.

The display device 10 may include a display panel 100, a display driving circuit 200, and a circuit board 300.

The display panel 100 may include a main region MA disposed on one surface where an image is displayed, and a sub-region SBA protruding from one side of the main region MA.

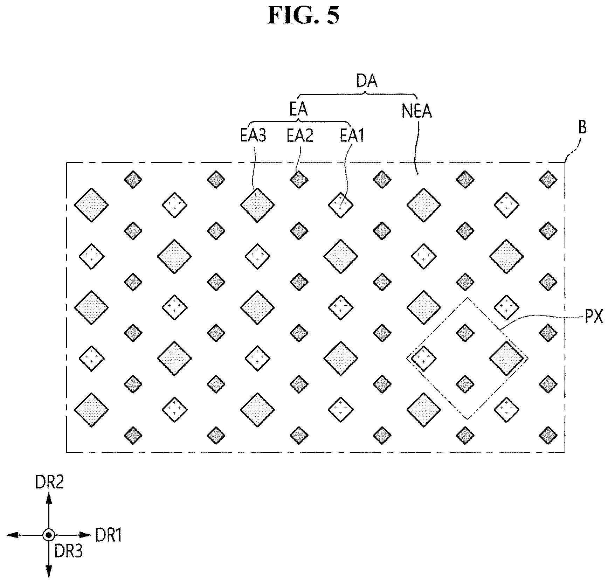

The main region MA may include a display area DA in which emission areas EA (see FIG. 5) for emitting light with respective colors and luminances are arranged for displaying an image, and a non-display area NDA disposed around the display area DA.

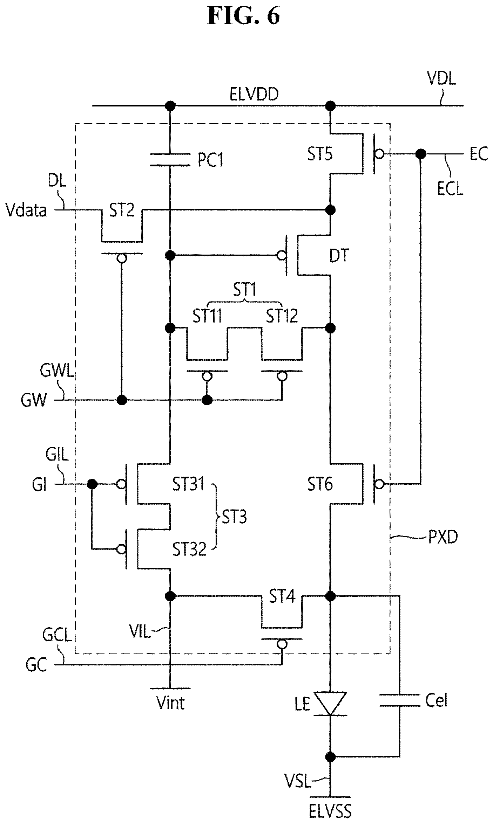

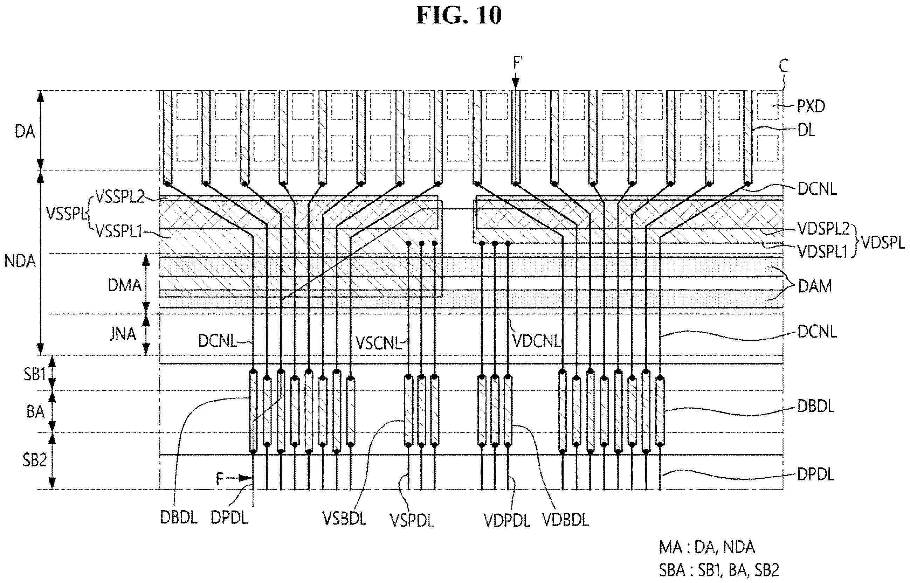

The display driving circuit 200 may be implemented as an integrated circuit chip ("IC") and mounted in the sub-region SBA. The display driving circuit 200 may supply data signals to data lines DL (see FIGS. 6 and 10) of the display panel 100. In an embodiment, the non-display area NDA and the sub-region SBA may not include the emission areas EA.

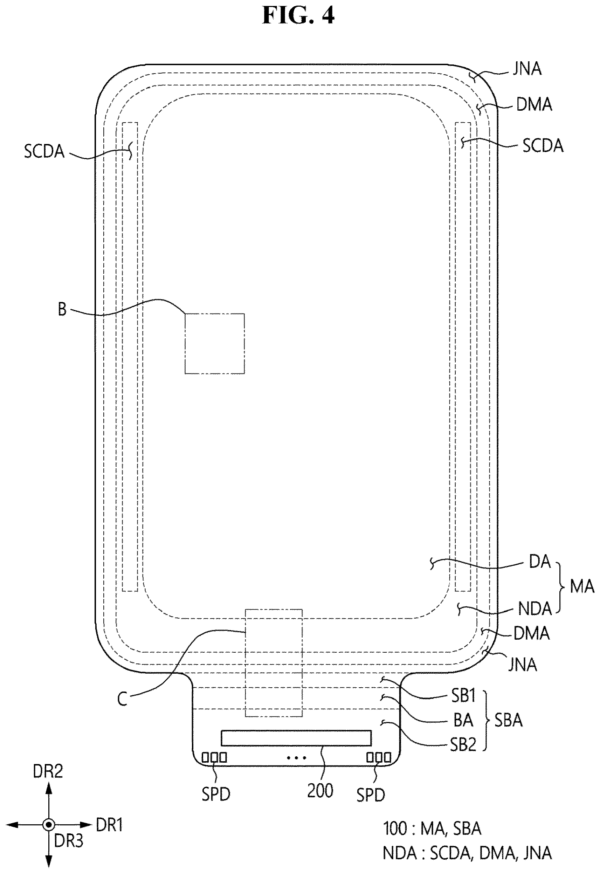

The circuit board 300 may be bonded to signal pads SPD (see FIG. 4) disposed at the edge of the sub-region SBA.

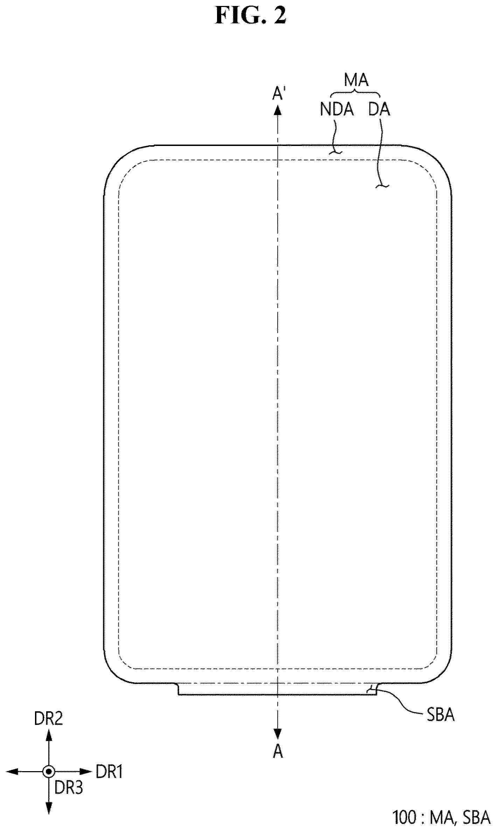

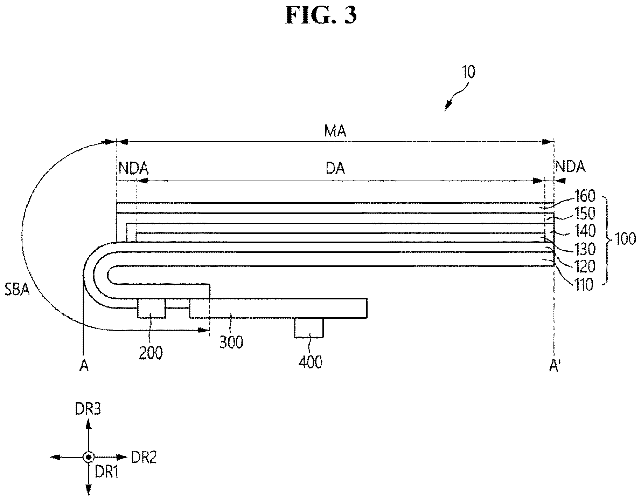

FIG. 2 is a plan view illustrating the display device of FIG. 1. FIG. 3 is a cross-sectional view taken along line A-A' of FIG. 2. FIG. 4 is a plan view illustrating the main region and the sub-region of the display device of FIG. 1 according to an embodiment.

FIGS. 1 and 4 illustrate a state in which the sub-region SBA is unfolded to be disposed side by side with the main region MA. On the other hand, FIG. 2 illustrates a state in which a part of the sub-region SBA is bent.

Referring to FIG. 2, the display area DA may, in a plan view, be formed in a rectangular shape having short sides in a first direction DR1 and long sides in the second direction DR2 crossing the first direction DR1. The corner where the short side in the first direction DR1 and the long side in the second direction DR2 meet may be rounded to have a predetermined curvature or may be right-angled. The planar shape of the display area DA is not limited to the rectangular shape, and may be formed in another polygonal shape, a circular shape or an elliptical shape.

The display area DA may occupy most of the main region MA. The display area DA may be disposed at the center of the main region MA.

Referring to FIG. 3, the display panel 100 of the display device 10 includes a substrate 110 including the main region MA and the sub-region SBA, a circuit layer 120 disposed on the substrate 110, a light emitting element layer 130 disposed on the circuit layer 120, and an encapsulation layer 140 disposed on the light emitting element layer 130.

The display panel 100 of the display device 10 according to one embodiment may further include a polarization layer 160 disposed on the encapsulation layer 140 and overlapping the light emitting element layer 130 in a plan view.

Further, the display panel 100 of the display device 10 according to one embodiment may further include a touch sensor layer 150 disposed on the encapsulation layer 140. That is, the polarization layer 160 may be disposed on the touch sensor layer 150.

The substrate 110 may be formed of an insulating material such as a polymer resin. In an embodiment, for example, the substrate 110 may be formed of polyimide. The substrate 110 may be a flexible substrate which can be bent, folded or rolled.

Alternatively, the substrate 110 may be formed of an insulating material such as glass or the like.

The circuit layer 120 may include pixel drivers PXD (see FIG. 6) corresponding to the emission areas EA, respectively. Each of the pixel drivers PXD may include two or more transistors DT and ST1 to ST6 (see FIG. 6) and at least one capacitor PC1 (see FIG. 6).

The light emitting element layer 130 may include light emitting elements LE (see FIG. 6) respectively corresponding to the emission areas EA. The light emitting elements LE of the light emitting element layer 130 may be electrically connected to the pixel drivers PXD of the circuit layer 120, respectively.

The encapsulation layer 140 may cover the light emitting element layer 130 and may extend into the non-display area NDA to be contact with the circuit layer 120. The encapsulation layer 140 may include a structure in which two or more inorganic layers and at least one organic layer are alternately stacked.

The touch sensor layer 150 may be disposed on the encapsulation layer 140 and may correspond to the main region MA. The touch sensor layer 150 may include touch electrodes for sensing a touch of a person or an object.

The polarization layer 160 blocks external light reflected from the touch sensor layer 150, the encapsulation layer 140, the light emitting element layer 130, and the circuit layer 120, and the interfaces thereof, and this is to prevent the deterioration of visibility of an image due to external light reflection.

The display device 10 may further include a cover window (not shown) disposed on the polarization layer 160. The cover window may be attached to the polarization layer 160 by a transparent adhesive member such as an optically clear adhesive ("OCA") film or an optically clear resin ("OCR"). The cover window may be made of an inorganic material such as glass, or an organic material such as plastic or a polymer material. Due to the cover window, the touch sensor layer 150, the encapsulation layer 140, the light emitting element layer 130, and the circuit layer 120 may be protected from electrical and physical impact on the display surface.

The display device 10 according to one embodiment may further include a touch driving circuit 400 for driving the touch sensor layer 150.

The touch driving circuit 400 may be provided as an integrated circuit chip (IC).

The touch driving circuit 400 may be electrically connected to the touch sensor layer 150 while being mounted on the circuit board 300 bonded to the signal pads SPD.

Alternatively, similarly to the display driving circuit 200, the touch driving circuit 400 may be mounted on the second sub-region SB2 of the substrate 110.

The touch driving circuit 400 may apply a touch driving signal to a plurality of driving electrodes provided on the touch sensor layer 150, receive a touch sensing signal of each of a plurality of touch nodes through a plurality of sensing electrodes, and sense a charge change amount of mutual capacitance based on the touch sensing signal.

That is, the touch driving circuit 400 may determine whether the user's touch has been made, whether the user is in proximity, and so forth, according to the touch sensing signals of each of the plurality of touch nodes. The user's touch refers to a direct contact of an object such as a pen or a user's finger with the front surface of the display device 10. The user's being in proximity means that an object such as a pen or a user's finger is positioned away from the front surface of the display device 10, such as hovering.

Referring to FIG. 4, the non-display area NDA may include a dam area DMA spaced apart from the display area DA and surrounding the display area DA, and a junction area JNA disposed around the dam area DMA.

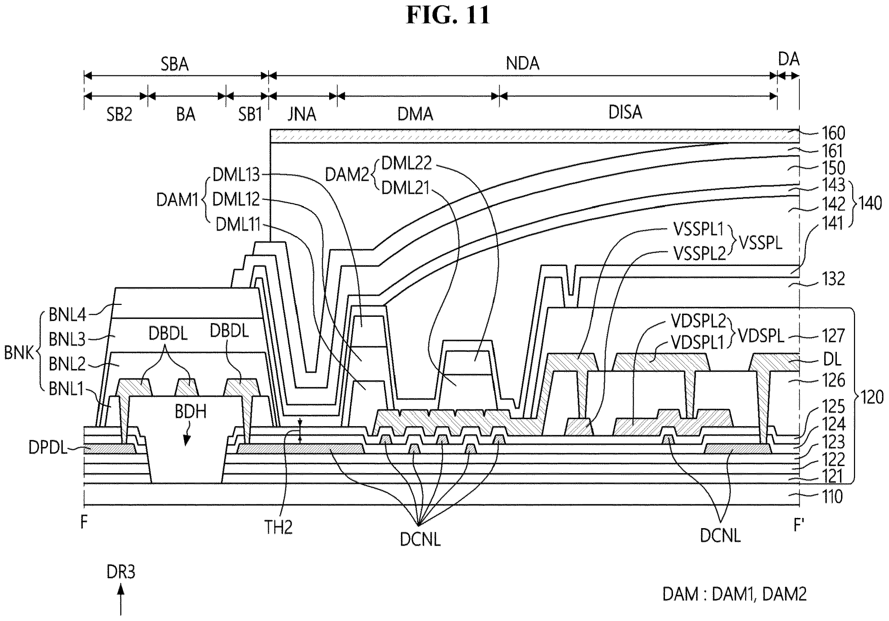

At least one dam portion DAM (see FIGS. 10 and 11) surrounding the display area DA may be arranged in the dam area DMA. At least one dam portion DAM is to limit an area in which the organic layer of the encapsulation layer 140 diffuses. That is, diffusion of the organic layer may be limited by valleys generated between the at least one dam portion DAM and the display area DA and between the dam portions DAM.

A bonding between the encapsulation layer 140 and the inorganic insulating materials provided in the circuit layer 120 may be provided in the junction area JNA.

In addition, the non-display area NDA may further include a scan driving circuit area SCDA disposed adjacent to at least one edge of the display area DA in the first direction DR1.

The circuit layer 120 may include a scan driving circuit (not shown) disposed in the scan driving circuit area SCDA. The scan driving circuit may supply respective scan signals to the scan lines disposed in the first direction DR1 in the display area DA.

In an embodiment, for example, the display driving circuit 200 or the circuit board 300 may supply a scan control signal to the scan driving circuit based on digital video data and timing signals.

In addition, the circuit board 300 may supply a predetermined constant voltage for generating the scan signal to the scan driving circuit.

FIG. 4 illustrates a case in which the scan driving circuit area SCDA is a part of the non-display area NDA adjacent to opposite corners of the display area DA in the first direction DR1, but this is nothing more than an example. That is, although not shown separately, the scan driving circuit area SCDA may be a part of the non-display area NDA adjacent to one side of the display area DA in the first direction DR1, or may be divided areas overlapping some of the display area DA.

According to one embodiment, the sub-region SBA may include a bending area BA that is bendable, and a first sub-region SB1 and a second sub-region SB2 that are in contact with opposite sides of the bending area BA.

The first sub-region SB1 is disposed between the main region MA and the bending area BA. One side of the first sub-region SB1 may be in contact with the non-display area NDA of the main region MA, and the other side of the first sub-region SB1 may be in contact with the bending area BA.

The second sub-region SB2 is spaced apart from the main region MA with the bending area BA interposed therebetween, and is disposed on the bottom surface of the substrate 110 by the bending area BA bendable. That is, the second sub-region SB2 may overlap the main region MA in a thickness direction DR3 of the substrate 110 due to the bending area BA bendable.

One side of the second sub-region SB2 may be in contact with the bending area BA. The other side of the second sub-region SB2 may be in contact with a part of the edge of the substrate 110.

The signal pads SPD and the display driving circuit 200 may be disposed in the second sub-region SB2.

The display driving circuit 200 may generate signals and voltages for driving the pixel drivers PXD of the display area DPA.

The display driving circuit 200 may be provided as an integrated circuit (IC) and mounted on the second sub-region SB2 of the substrate 110 by a chip on glass ("COG") method, a chip on plastic ("COP") method, or an ultrasonic bonding method, but the present invention is not limited thereto. For another example, the display driving circuit 200 may be attached onto the circuit board 300 by a chip on film ("COF") method.

The circuit board 300 may be attached and electrically connected to the signal pads PD of the second sub-region SB2 using a low-resistance high-reliability material such as SAP or an anisotropic conductive film.

The pixel drivers PXD of the display area DPA and the display driving circuit 200 may receive digital video data, timing signals, and driving voltages from the circuit board 300.

The circuit board 300 may be a flexible printed circuit board, a printed circuit board, or a flexible film such as a chip on film.

FIG. 5 is a layout diagram illustrating part B of FIG. 4.

Referring to FIG. 5, the display area DA may include the emission areas EA and a non-emission area NEA which is a separation area disposed between the emission areas EA.

Each of the emission areas EA may be a unit that emits light in a wavelength band corresponding to one color of two or more different colors with a luminance corresponding to an image signal.

In an embodiment, for example, the emission areas EA may include a first emission area EA1 for emitting light of a first color having a predetermined wavelength band, a second emission area EA2 for emitting light of a second color having a wavelength band lower than the wavelength band of the first color, and a third emission area EA3 for emitting light of a third color having a wavelength band lower than the wavelength band of the second color.

In an embodiment, for example, the first color may be red having a wavelength band of approximately 600 nanometers (nm) to approximately 750 nm, the second color may be green having a wavelength band of approximately 480 nm to approximately 560 nm, and the third color may be blue having a wavelength band of approximately 370 nm to approximately 460 nm. However, this is only an example, and the wavelength bands of the first color, the second color, and the third color according to one embodiment of this specification are not limited thereto.

Since the emission areas EA include the first emission area EA1, the second emission area EA2, and the third emission area EA3, each of unit pixels UPX may be provided by a combination of one or more first emission areas EA1, one or more second emission areas EA2, and one or more third emission areas EA3 adjacent to each other among the emission areas EA.

Each of the unit pixels UPX may be a unit for displaying various colors including white. That is, lights of various colors displayed by the unit pixels UPX may be implemented as a mixture of lights emitted from two or more emission areas EA included in each unit pixel UPX.

In an embodiment, for example, as illustrated in FIG. 5, the first emission areas EA1 and the third emission areas EA3 may be alternately arranged in the first direction DR1 and the second direction DR2. Further, the second emission areas EA2 may be arranged in parallel in the first direction DR1 and the second direction DR2, and may be adjacent to the first emission areas EA1 or the third emission areas EA3 in a diagonal direction intersecting the first direction DR1 and the second direction DR2.

In this case, each of the unit pixels UPX may include one first emission area EA1 and one third emission area EA3 adjacent to each other in the first direction DR1, and two second emission areas EA2 adjacent thereto in a diagonal direction. However, this is only an example, and the arrangement pattern of the emission areas EA and the components of the unit pixel UPX according to one embodiment are not limited to those illustrated in FIG. 5.

FIG. 6 is an equivalent circuit diagram illustrating one pixel driver corresponding to one emission area among the pixel drivers included in the circuit layer of FIG. 3.

FIG. 6 is an equivalent circuit diagram showing one pixel driver of the circuit layer of FIG. 3.

The circuit layer 120 of the display device 10 according to one embodiment includes the pixel drivers PXD corresponding to the emission areas EA, respectively, and a data line DL configured to transmit a data signal Vdata to the pixel drivers PXD. The pixel drivers PXD of the circuit layer 120 are electrically connected to the light emitting elements LE of the light emitting element layer 130, respectively.

The circuit layer 120 may further include a first power line VDL that transmits a first power ELVDD to the pixel driver PXD, and an initialization voltage line VIL that transmits an initialization voltage Vint to the pixel driver PXD.

Further, the circuit layer 120 may further include a scan write line GWL that transmits a scan write signal GW to the pixel driver PXD, a scan initialization line GIL that transmits a scan initialization signal GI to the pixel driver PXD, an emission control line ECL that transmits an emission control signal EM to the pixel driver PXD, and a gate control line GCL that transmits a gate control signal GC to the pixel driver PXD.

Referring to FIG. 6, one pixel driver PXD among the pixel drivers PXD of the circuit layer 120 may include a driving transistor DT generating a driving current to drive the light emitting element LE electrically connected to the one pixel driver PXD. In addition, one pixel driver PXD may further include two or more transistors ST1 to ST6 electrically connected to the driving transistor DT, and the at least one capacitor PC1.

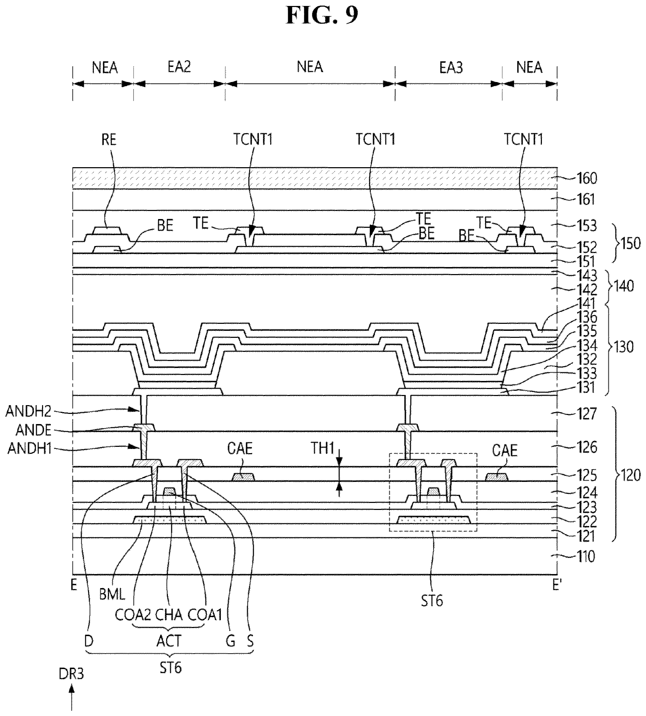

An anode electrode 131 (see FIG. 9) of the light emitting element LE may be electrically connected to the pixel driver PXD, and a cathode electrode 136 of FIG. 9 of the light emitting element LE may be electrically connected to a second power line VSL for transmitting a second driving power ELVSS that has a voltage level lower than a voltage level of the first power ELVDD.

The light emitting element LE may be an organic light emitting diode having a light emitting layer made of an organic light emitting material. Alternatively, the light emitting element LE may be an inorganic light emitting element including a light emitting layer made of an inorganic semiconductor. Alternatively, the light emitting element LE may be a quantum dot light emitting element having a quantum dot light emitting layer. Alternatively, the light emitting element LE may be a micro light emitting diode.

A capacitor Cel connected in parallel with the light emitting element LE refers to a parasitic capacitance between an anode electrode 131 and a cathode electrode 138.

The driving transistor DT is connected in series to the light emitting element LE between the first power line VDL and the second power line VSL. That is, the first electrode (e.g., the source electrode) of the driving transistor DT may be electrically connected to the first power line VDL through the fifth transistor ST5. Further, the second electrode (e.g., the drain electrode) of the driving transistor DT may be electrically connected to the anode electrode 131 of the light emitting element LE through the sixth transistor ST6.

The first electrode of the driving transistor DT may be electrically connected to the data line DL through the second transistor ST2.

The gate electrode of the driving transistor DT may be electrically connected to the first power line VDL through the first capacitor PC1. That is, the first capacitor PC1 may be electrically connected between the gate electrode of the driving transistor DT and the first power line VDL.

Accordingly, the potential of the gate electrode of the driving transistor DT may be maintained by the first power ELVDD of the first power line VDL.

Accordingly, when the data signal Vdata of the data line DL is transmitted to the first electrode of the driving transistor DT through the turned-on second transistor ST2, the voltage difference corresponding to the data signal Vdata and the first power ELVDD may be generated between the gate electrode of the driving transistor DT and the first electrodes of the driving transistor DT.

In this case, when the voltage difference between the gate electrode of the driving transistor DT and the first electrode of the driving transistor DT, that is, the gate-source voltage difference is greater than or equal to a threshold voltage, the driving transistor DT may be turned on.

Subsequently, when the fifth transistor ST5 and the sixth transistor ST6 are turned on, the driving transistor DT may be connected in series with the light emitting element LE between the first power line VDL and the second power line VSL. Accordingly, a drain-source current corresponding to the data signal Vdata may be generated by the turned-on driving transistor DT and may be supplied as a driving current of the light emitting element LE.

Accordingly, the light emitting element LE may emit light having a luminance corresponding to the data signal Vdata.

The second transistor ST2 may be connected between the first electrode of the driving transistor DT and the data line DL.

The first transistor ST1 may be connected between the gate electrode of the driving transistor DT and the second electrode of the driving transistor DT.

The first transistor ST1 may include a plurality of sub-transistors connected in series. In an embodiment, for example, the first transistor ST1 may include a first sub-transistor ST11 and a second sub-transistor ST12.

The first electrode of the first sub-transistor ST11 may be connected to the gate electrode of the driving transistor DT, the second electrode of the first sub-transistor ST11 may be connected to the first electrode of the second sub-transistor ST12, and the second electrode of the second sub-transistor ST12 may be connected to the second electrode of the driving transistor DT.

In this way, it is possible to prevent the potential of the gate electrode of the driving transistor DT from changing due to the leakage current caused by the first transistor ST1 that is not turned on.

The gate electrode of each of the second transistor ST2, the first sub-transistor ST11, and the second sub-transistor ST12 may be connected to the scan write line GWL.

Accordingly, when the scan write signal GW is transmitted through the scan write line GWL, the second transistor ST2, the first sub-transistor ST11, and the second sub-transistor ST12 may be turned on.

In this case, the data signal Vdata may be transmitted to the first electrode of the driving transistor DT through the turned-on second transistor ST2.

Further, the gate electrode of the driving transistor DT and the second electrode of the driving transistor DT may have the same potential through the turned-on first sub-transistor ST11 and the turned-on second sub-transistor ST12.

Accordingly, the driving transistor DT may be turned on.

The third transistor ST3 may be connected between the gate electrode of the driving transistor DT and an initialization voltage line VIL.

The third transistor ST3 may include a plurality of sub-transistors connected in series. In an embodiment, for example, the third transistor ST3 may include a third sub-transistor ST31 and a fourth sub-transistor ST32.

The first electrode of the third sub-transistor ST31 may be connected to the gate electrode of the driving transistor DT, the second electrode of the third sub-transistor ST31 may be connected to the first electrode of the fourth sub-transistor ST32, and the second electrode of the fourth sub-transistor ST32 may be connected to the initialization voltage line VIL.

In this way, it is possible to prevent the potential of the gate electrode of the driving transistor DT from changing due to the leakage current caused by the third transistor ST3 that is not turned on.

The gate electrode of each of the third sub-transistor ST31 and the fourth sub-transistor ST32 may be connected to the scan initialization line GIL.

Accordingly, when the scan initialization signal GI is transmitted through the scan initialization line GIL, the third sub-transistor ST31 and the fourth sub-transistor ST32 are turned on and, thus, the potential of the gate electrode of the driving transistor DT may be initialized to the initialization voltage Vint of the initialization voltage line VIL.

The fourth transistor ST4 may be connected between the anode electrode of the light emitting element LE and the initialization voltage line VIL.

The gate electrode of the fourth transistor ST4 may be connected to the gate control line GCL.

Accordingly, when the gate control signal GC is transmitted through the gate control line GCL, the fourth transistor ST4 may be turned on.

In this case, the potential of the anode electrode of the light emitting element LE may be initialized to the initialization voltage Vint of the initialization voltage line VIL through the turned-on fourth transistor ST4.

Accordingly, it is possible to prevent the light emitting element LE from being driven by the current remaining in the anode electrode.

The fifth transistor ST5 may be connected between the first electrode of the driving transistor DT and the first power line VDL.

The sixth transistor ST6 may be connected between the second electrode of the driving transistor DT and the anode electrode of the light emitting element LE.

The gate electrode of each of the fifth transistor ST5 and the sixth transistor ST6 may be connected to the emission control line ECL.

Accordingly, when the emission control signal EM is transmitted through the emission control line ECL, the fifth transistor ST5 and the sixth transistor ST6 are turned on and, thus, the drain-source current of the driving transistor DT may be supplied as the driving current of the light emitting element LE.

Although FIG. 6 illustrates a case in which the driving transistor DT and the first to sixth transistors ST1 to ST6 included in the pixel driver PXD are all N-type metal oxide semiconductor field effect transistors ("MOSFET"), it should be noted that the pixel driver PXD of one embodiment is not limited to that illustrated in FIG. 6. That is, at least one of the driving transistor DT and the first to sixth transistors ST1 to ST6 included in the pixel driver PXD according to one embodiment may be a P-type MOSFET.

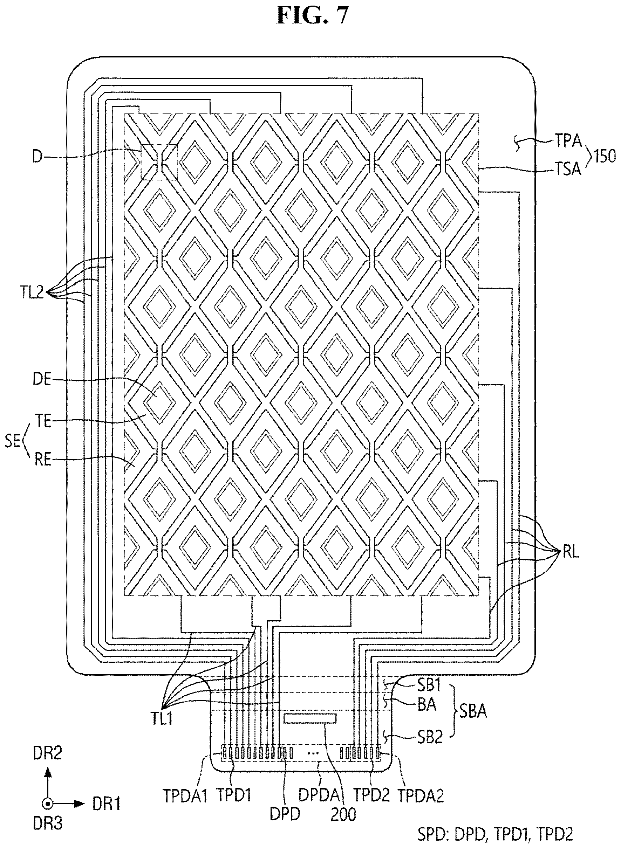

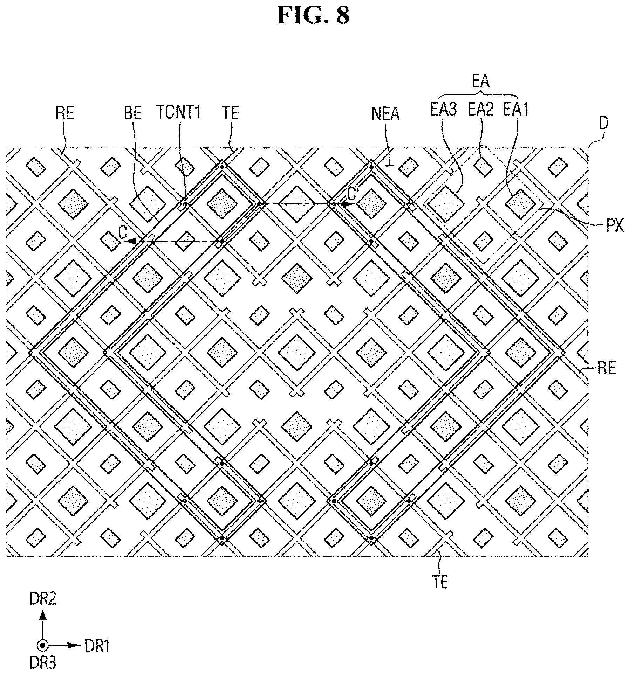

FIG. 7 is a plan view illustrating the touch sensor layer of FIG. 3. FIG. 8 is an enlarged view showing part D of FIG. 7. FIG. 9 is a cross-sectional view taken along line E-E' of FIG. 8.

FIG. 7 illustrates the touch sensor layer 150 of a capacitance method. In this case, the touch driving circuit 400 may sense a touch based on whether capacitance fluctuations. However, FIG. 7 is merely an example for easy description, and the touch sensor layer 150 according to one embodiment is not limited to that illustrated in FIG. 7.

FIG. 7 illustrates only some of the components of the touch sensor layer 150 for simplicity of description.

Referring to FIG. 7, the touch sensor layer 150 may be disposed in the main region MA. The touch sensor layer 150 may include a touch sensing area TSA for sensing a user's touch and a touch periphery area TPA around the touch sensing area TSA.

The touch sensing area TSA has a wider width than the display area DA and may be similar to the display area DA. Accordingly, the touch periphery area TPA, which is a periphery of the touch sensing area TSA, may be similar to the non-display area NDA, which is a periphery of the display area DA.

In an embodiment, for example, the touch sensing area TSA may overlap the display area DA and the edge of the non-display area NDA in contact with the display area DA. In this case, the touch periphery area TPA may overlap the remaining part of the non-display area NDA that does not correspond to the touch sensing area TSA.

The touch sensor layer 150 may include sensor electrodes SE and dummy electrodes DE that are matrix-arranged in the touch sensing area TSA and generate mutual capacitance, and sensor lines SENL disposed in the touch periphery area TPA.

The sensor electrodes SE may include a driving electrode TE (touch driving electrode) to which a driving signal is applied, and a sensing electrode RE (receiving electrode) to sense a voltage charged in mutual capacitance with the driving electrode TE.

The sensor lines SENL may include a first driving line TL1, a second driving line TL2, and a sensing line RL.

Each of the first driving line TL1 and the second driving line TL2 may be electrically connected to two or more driving electrodes TE extending in the second direction DR2 among the driving electrodes TE.

The first driving line TL1 may extend from a part of the touch periphery area TPA between one side of the touch sensing area TSA in the second direction DR2 and the sub-region SBA, to the sub-region SBA.

The second driving line TL2 may extend from a part of the touch periphery area TPA, which is in contact with the other side of the touch sensing area TSA in the second direction DR2, to the sub-region SBA through a portion of the touch periphery area TPA that is in contact with one side of the touch sensing area TSA in the first direction DR1.

The sensing line RL may be electrically connected to two or more sensing electrodes RE extending in the first direction DR1 among the sensing electrodes RE.

The sensing electrodes RE may be arranged in parallel in the first direction DR1. The sensing electrodes RE adjacent in the first direction DR1 may be electrically connected to each other through a protruding portion in the first direction DR1.

The driving electrodes TE may be arranged in parallel in the second direction DR2. The driving electrodes TE adjacent in the second direction DR2 may be electrically connected to each other through a bridge electrode BE (see FIG. 8) in the second direction DR2.

Each of the driving electrodes TE and the sensing electrodes RE may have a shape surrounding the dummy electrode DE disposed in the center thereof.

Each of the dummy electrodes DE may be spaced apart from the driving electrode TE or the sensing electrode RE that surrounds it. The dummy electrode DE may be maintained in a floating state.

Although FIG. 7 illustrates that each of the driving electrode TE, the sensing electrode RE, and the dummy electrode DE has a rhombic planar shape, one embodiment is not limited to that illustrated in FIG. 7. In an embodiment, for example, the planar shape of the driving electrode TE, the sensing electrode RE, and the dummy electrode DE may be a quadrilateral shape other than a rhombus, a polygonal shape other than a quadrilateral shape, a circular shape, or an elliptical shape.

The display panel 100 of the display device 10 according to one embodiment may include the signal pads SPD disposed in the second sub-region SB2 and connected to the circuit board 300.

The signal pads SPD may include display signal pads DPD for transmitting and receiving signals to drive the circuit layer 120, and touch signal pads TPD1 and TPD2 for transmitting and receiving signals to drive the touch sensor layer 150.

In an embodiment, for example, the second sub-region SB2 may include a display pad area DPDA adjacent to the display driving circuit 200, and a first touch pad area TPDA1 and a second touch pad area TPDA2 disposed on opposite sides of the display pad area DPDA.

The display pads DPD for transmitting and receiving signals that are transmitted to the circuit layer 120 or the display driving circuit 200 may be disposed in the display pad area DPDA.

The first touch pads TPD1 electrically connected to the first driving line TL1 and the second driving line TL2, respectively, may be disposed in the first touch pad area TPDA1.

The second touch pads TPD2 electrically connected to the sensing line RL, respectively, may be disposed in the second touch pad area TPDA2.

Referring to FIG. 8, the bridge electrode BE may be provided as a first touch sensor layer SSEL1, and the driving electrode TE and the sensing electrode RE may be provided as a second touch sensor layer SSEL2.

The driving electrode TE and the sensing electrode RE may be spaced apart from each other.

Although FIG. 8 illustrates the bridge electrode BE having a shape including at least one bend, the shape of the bridge electrode BE according to one embodiment is not limited to that illustrated in FIG. 8.

The driving electrodes TE adjacent in the second direction DR2 may be electrically connected to each other through two or more bridge electrodes BE. In this way, reliability of the electrical connection between the driving electrodes TE may be improved.

Although FIG. 8 illustrates that two bridge electrodes BE parallel to each other are disposed between the driving electrodes TE adjacent to each other in the second direction DR2, one embodiment is not limited to that illustrated in FIG. 8.

The bridge electrode BE may be electrically connected to the driving electrodes TE through touch contact holes TCNT1.

The driving electrode TE, the sensing electrode RE, and the bridge electrode BE may have a mesh or net structure in a plan view. The dummy electrodes DE may also have a mesh or net structure in a plan view. In this way, since the overlapping width of the driving electrode TE, the sensing electrode RE, the dummy electrode DE, and the bridge electrode BE in the emission areas EA may be reduced, a decrease in light emission efficiency due to the driving electrode TE, the sensing electrode RE, the dummy electrode DE, and the bridge electrode BE may be reduced.

The emission areas EA may include the first emission area EA1 emitting light of the first color, the second emission area EA2 emitting light of the second color having a wavelength band lower than the wavelength band of the first color, and the third emission area EA3 emitting light of the third color having a wavelength band lower than the wavelength band of the second color. In an embodiment, for example, the first color, the second color, and the third color may be red, green, and blue, respectively.

The first emission area EA1 and the third emission area EA3 may be alternately arranged in the first direction DR1 and the second direction DR2.

The second emission area EA2 may be adjacent to each of the first emission area EA1 and the third emission area EA3 in an oblique direction oblique to the first direction DR1 and the second direction DR2. The second emission area EA2 may be arranged in parallel in the first direction DR1 and the second direction DR2.

Although FIG. 8 illustrates that each of the emission areas EA has a rhombic or rectangular planar shape, the planar shape of the emission areas EA according to one embodiment is not limited to that illustrated in FIG. 8. That is, each of the emission areas EA may have a planar shape such as a polygonal shape other than a quadrilateral shape, a circular shape, or an elliptical shape.

As illustrated in FIG. 8, in a case where the first color of the first emission area EA1, the second color of the second emission area EA2, and the third color of the third emission area EA3 are red, green, and blue, respectively, the third emission area EA3 may have a larger width than the first emission area EA1, and the second emission area EA2 may have a smaller width than the first emission area EA1. However, this is merely an example, and the width of each of the emission areas EA is not limited to that illustrated in FIG. 8.

Referring to FIG. 9, the display panel 100 of the display device 10 according to one embodiment may include the substrate 110, the circuit layer 120 on the substrate 110, the light emitting element layer 130 on the circuit layer 120, the encapsulation layer 140 on the light emitting element layer 130, and the touch sensor layer 150 on the encapsulation layer 140.

The substrate 110 may be made of a material having a flexible characteristic capable of bending, folding, rolling, or the like.

The substrate 110 may be formed of an insulating material such as a polymer resin. In an embodiment, for example, the substrate 110 may be made of polyimide.

The circuit layer 120 may include the pixel drivers PXD corresponding to the emission areas EA, respectively.

Each of the pixel drivers PXD may include two or more transistors DT and ST1 to ST6 (see FIG. 6) and the at least one capacitor PC1 (see FIG. 6).

The circuit layer 120 may include conductive layers for preparing the pixel drivers PXD and the lines GWL, GIL, ECL, GCL, DL, VIL, VDL, and VSL (see FIG. 6) electrically connected to the pixel drivers PXD, and insulating layers 121 to 127 disposed between the conductive layers.

The circuit layer 120 includes a semiconductor layer ACT disposed on the substrate 110, a first insulating layer 123 disposed on the substrate 110, covering the semiconductor layer ACT, and including an inorganic insulating material, a first conductive layer G disposed on the first insulating layer 123, a second insulating layer 124 disposed on the first insulating layer 123, covering the first conductive layer G, and including an inorganic insulating material, a second conductive layer CAE disposed on the second insulating layer 124, a third insulating layer 125 disposed on the second insulating layer 124, covering the second conductive layer CAE, and including an inorganic insulating material, third conductive layers S and D disposed on the third insulating layer 125, a fourth insulating layer 126 disposed on the third insulating layer 125, covering the third conductive layers S and D, and including an organic insulating material, a fourth conductive layer ANDE disposed on the fourth insulating layer 126, and a fifth insulating layer 127 disposed on the fourth insulating layer 126, covering the fourth conductive layer ANDE, and including an organic insulating material.

The fourth insulating layer 126 includes a first planarization layer corresponding to the display area DA. Further, the fifth insulating layer 127 includes a second planarization layer corresponding to the display area DA and covering the fourth insulating layer 126. In the following description, the fourth insulating layer 126 may be referred to by the same reference numeral as the first planarization layer, and the fifth insulating layer 127 may be referred to by the same reference numeral as the second planarization layer.

The semiconductor layer ACT may include the active layers of the transistors DT and ST1 to ST6 (hereinafter, the same reference character "ACT" is also used to indicate the active layer). The semiconductor layer may include polycrystalline silicon, monocrystalline silicon, low-temperature polycrystalline silicon, amorphous silicon, or an oxide semiconductor material.

The first conductive layer G on the first insulating layer 123 may include gate electrodes of the transistors DT and ST1 to ST6 (hereinafter, the same reference character "G" is also used to indicate the gate electrodes).

The second conductive layer CAE on the second insulating layer 124 may include the first capacitor electrode of the capacitor PC 1 (hereinafter, the same reference character "CAE" is also used to indicate the first capacitor electrode).

The third conductive layer on the third insulating layer 125 may include source electrodes, which may be defined by the third conductive layer S, of the transistors DT and ST1 to ST6 and drain electrodes, which may be defined by the third conductive layer D, of the transistors DT and ST1 to ST6.

The fourth conductive layer ANDE on the fourth insulating layer 126 may include anode connection electrodes corresponding to the emission areas EA, respectively, (hereinafter, the same reference character "ANDE" is also used to indicate the anode connection electrodes).

Further, the circuit layer 120 may further include a first buffer layer 121 to block oxygen or moisture transmitted through the substrate 110, the light blocking layer BML to block light transmitted through the substrate 110, and a second buffer layer 122 covering the light blocking layer BML. In this case, the semiconductor layer may be disposed on the second buffer layer 122.

Each of the first buffer layer 121 and the second buffer layer 122 may include an inorganic insulating material.

In an embodiment, for example, each of the first buffer layer 121 and the second buffer layer 122 may be formed of multiple layers in which one or more inorganic layers of a silicon nitride layer, a silicon oxynitride layer, a silicon oxide layer, a titanium oxide layer and an aluminum oxide layer are alternately stacked.

The light blocking layer BML is to prevent leakage current of the active layer ACT due to light introduced through the substrate 110. To this end, the light blocking layer BML may overlap at least a channel area CHA of the active layer ACT on the second buffer layer 122 in a plan view. Alternatively, the light blocking layer BML may overlap the entirety of the active layer ACT in a plan view.

The light blocking layer BMI, may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. Alternatively, the light blocking layer BML may be an organic layer including a black pigment.

Each of two or more transistors DT and ST1 to ST6 provided in each of the pixel drivers PXD may include the light blocking layer BML on the substrate 110, the active layer ACT on the second buffer layer 122 covering the light blocking layer BML, the gate electrode, which may be defined by the first conductive layer G, disposed on the first insulating layer 123 covering the active layer ACT, and the source electrode, which may be defined by the third conductive layer S, and the drain electrode, which may be defined by the third conductive layer D, disposed on the third insulating layer 125.

The active layer ACT may include the channel area CHA where a channel is formed due to a potential difference, and a first electrode area COA1 and a second electrode area COA2 positioned on opposite sides of the channel area CHA.

When the active layer ACT includes polycrystalline silicon or an oxide semiconductor material, the first electrode area COA1 and the second electrode area COA2 may be conductive areas obtained by ion doping.

Each of the first insulating layer 123, the second insulating layer 124, and the third insulating layer 125 includes an inorganic insulating material. In an embodiment, for example, each of the first insulating layer 123, the second insulating layer 124, and the third insulating layer 125 may be formed of an inorganic insulating layer of a silicon nitride layer, a silicon oxynitride layer, a silicon oxide layer, a titanium oxide layer, or an aluminum oxide layer. Here, the third insulating layer 125 may be formed of a silicon nitride layer.

The gate electrode, which may be defined by the first conductive layer G, may overlap the channel area CHA of the active layer ACT in the third direction DR3 (i.e., in a plan view).

The first conductive layer including the gate electrodes G of the transistors DT and ST1 to ST6 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second conductive layer including the first capacitor electrode CAE of the capacitor PC1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The third conductive layer S including the source electrodes of the transistors DT and ST1 to ST6 and the drain electrodes of the transistors DT and ST1 to ST6 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The fourth conductive layer ANDE including the anode connection electrodes may be formed as a single layer or multiple layers made of any one of molybdenum (Mo), aluminum (Al), chromium (Cr), gold (Au), titanium (Ti), nickel (Ni), neodymium (Nd) and copper (Cu), or an alloy thereof.

Here, each of the third conductive layer and the fourth conductive layer may include a triple layer including a low-resistance metal layer such as molybdenum (Mo), aluminum (Al), copper (Cu), and nickel (Ni) and diffusion prevention metal layers such as titanium (Ti) disposed on opposite sides of the low-resistance metal.

Each of the fourth insulating layer 126 and the fifth insulating layer 127 may include an organic insulating material for planarization of the circuit layer 120.

In an embodiment, for example, each of the fourth insulating layer 126 and the fifth insulating layer 127 may be formed of an organic layer such as acryl resin, epoxy resin, phenolic resin, polyamide resin, polyimide resin and the like.

According to the illustration in FIG. 9, although the transistors DT and ST1 to ST6 of the circuit layer 120 have a top gate (top gate) structure including the gate electrode, which may be defined by the first conductive layer G, positioned above the active layer ACT, one embodiment is not limited to that illustrated in FIG. 9. That is, the transistors DT and ST1 to ST6 of the circuit layer 120 may be a bottom gate (bottom gate) structure in which the gate electrode is positioned below the active layer ACT, or may be a double gate structure in which the gate electrode is positioned both above and below the active layer ACT.

The light emitting element layer 130 may be disposed on the fifth insulating layer 127 of the circuit layer 120 and may include the light emitting elements LE corresponding to the emission areas EA, respectively.

The light emitting element layer 130 may include the anode electrodes 131 disposed on the fifth insulating layer 127 of the circuit layer 120 and corresponding to the emission areas EA, respectively, a pixel defining layer 132 disposed on the fifth insulating layer 127 of the circuit layer 120, corresponding to the non-emission area NEA, which is a separation area between the emission areas EA, and covering the edge of each of the anode electrodes 131, a spacer layer (not illustrated) disposed on a part of the pixel defining layer 132, first common layers 133 disposed on the anode electrodes 131, respectively, light emitting layers 134 disposed on the first common layers 133, respectively, a second common layer 135 disposed on the pixel defining layer 132, the spacer layer, and the light emitting layer 134, and a cathode electrode 136 disposed on the second common layer 135.

Here, each of the light emitting elements LE may include a structure in which the first common layer 133, the light emitting layer 134, and the second common layer 135 made of an organic material are disposed between the anode electrode 131 and the cathode electrode 136 facing each other.

The anode electrodes 131 may be electrically connected to the pixel drivers PXD of the circuit layer 120, respectively, through the anode connection electrodes ANDE.

That is, in each of the emission areas EA, the anode connection electrode ANDE may be electrically connected to the drain electrode, which may be defined by the third conductive layer D, of the sixth transistor ST6 of the pixel driver PXD through a first anode connection hole ANDH1 penetrating the fourth insulating layer 126, and the anode electrode 131 may be electrically connected to the anode connection electrode ANDE through a second anode connection hole ANDH2 penetrating the fifth insulating layer 127.

As such, the anode electrode 131 is electrically connected to the pixel driver PXD of each of the emission areas EA, and thus may be referred to as a pixel electrode.

The anode electrode 131 may be formed of a metal material, having high reflectivity, such as a stacked structure (Ti/Al/Ti) of aluminum (Al) and titanium (Ti), a stacked structure (ITO/Al/ITO) of Al and indium tin oxide ("ITO"), an APC alloy, a stacked structure (ITO/APC/ITO) of an APC alloy and ITO, or the like. The APC alloy is an alloy of silver (Ag), palladium (Pd) and copper (Cu).

The first common layers 133 may correspond to the emission areas EA, respectively. Each of the first common layers 133 may include a hole transporting layer. Alternatively, each of the first common layers 133 may further include a hole injection layer disposed between the anode electrode 131 and the hole transporting layer.

The light emitting layers 134 may correspond to the emission areas EA, respectively.

The light emitting layer 134 of the first emission area EA1, the light emitting layer 134 of the second emission area EA2, and the light emitting layer 134 of the third emission area EA3 may include organic light emitting materials having different materials or contents.

In an embodiment, for example, the light emitting layer 134 may be formed of an organic light emitting material that converts electron-hole pairs into light.

The organic light emitting material may include a host material and a dopant. The dopant may include a phosphorescent material or a fluorescent material.

The light emitting layer 134 of the first emission area EA1 emitting the first color may include a host material including carbazole biphenyl ("CBP") or 1,3-bis (carbazol-9-yl) ("mCP").

Further, the dopant of the light emitting layer 134 of the first emission area EA1 may be selected as any one or more phosphorescent materials selected among bis(1-phenylisoquinoline)acetylacetonate iridium (PIQIr(acac)), bis(1-phenylquinoline)acetylacetonate iridium (PQIr(acac)), tris(1-phenylquinoline)iridium ("PQIr"), and octaethylporphyrin platinum ("PtOEP"), or a florescent material including PBD:Eu("DBM")3(Phen) or perylene.

The light emitting layer 134 of the second emission area EA2 emitting the second color having a wavelength band lower than the wavelength band of the first color may include a host material including CBP or mCP.

Further, a phosphorescent material including fac tris(2-phenylpyridine)iridium (Ir(ppy)3), or a fluorescent material including tris(8-hydroxyquinolino)aluminum (Alq3) may be selected as the dopant of the light emitting layer 134 of the second emission area EA2.

The light emitting layer 134 of the third emission area EA3 emitting the third color having a wavelength band lower than the wavelength band of the second color may include a host material including CBP or mCP.

A phosphorescent material including (4,6-F2ppy)2Irpic or L2BD111 may be selected as the dopant of the light emitting layer 134 of the third emission area EA3.

The description of the organic light emitting material of the light emitting layer 134 is only an example, and the material of the light emitting layer 134 according to one embodiment is not limited to the above description.

The second common layer 135 may entirely correspond to the display area DA including the emission areas EA. The second common layer 135 may include an electron transporting layer. Alternatively, the second common layer 135 may further include an electron injection layer disposed between the cathode electrode 136 and the electron transporting layer.

The cathode electrode 136 may entirely correspond to the display area DA including the emission areas EA. The cathode electrode 136 may be electrically connected to the second power line VSL (see FIG. 6) to which the second power ELVSS is applied.

The cathode electrode 136 entirely corresponds to the emission areas EA, and thus may be referred to as a common electrode.

The cathode electrode 136 may include a transparent conductive material ("TCO") such as ITO or IZO that can transmit light or a semi-transmissive conductive material such as magnesium (Mg), silver (Ag), or an alloy of Mg and Ag. When the cathode electrode 136 is made of a semi-transmissive conductive material, an improvement in light output efficiency due to a micro cavity effect may be expected.

The encapsulation layer 140 is to block the permeation of oxygen or moisture into the light emitting element layer 130 and to reduce electrical or physical shock to the circuit layer 120 and the light emitting element layer 130.

The encapsulation layer 140 may include a first encapsulation layer 141 disposed on the circuit layer 120, covering the light emitting element layer 130, and including an inorganic insulating material, a second encapsulation layer 142 disposed on the first encapsulation layer 141, overlapping the light emitting element layer 130 in a plan view, and including an organic insulating material, and a third encapsulation layer 143 disposed on the first encapsulation layer 141, covering the second encapsulation layer 142, and including an inorganic insulating material.

The second encapsulation layer 142 may be formed of an organic insulating material such as acryl resin, epoxy resin, phenolic resin, polyamide resin, polyimide resin and the like.

The second encapsulation layer 142 may be prepared by a process in which an organic material in a liquid state is dropped onto the first encapsulation layer 141, is diffused to cover the display area DA, and then is cured.

Accordingly, according to the embodiment of FIG. 4, the display panel 100 of the display device 10 may further include the dam (see FIGS. 10 and 11) to limit the diffusion range of the organic material of the second encapsulation layer 142. The dam may be disposed in the dam area DMA of the non-display area NDA.

The second encapsulation layer 142 diffuses to the dam area DMA in which the at least one dam is disposed. Accordingly, in the junction area JNA disposed around the dam area DMA in the non-display area NDA, the third encapsulation layer 143 may be bonded to the first encapsulation layer 141.

Each of the first encapsulation layer 141 and the third encapsulation layer 143 may have a structure in which one or more inorganic layers of a silicon nitride layer, a silicon oxynitride layer, a silicon oxide layer, a titanium oxide layer, and an aluminum oxide layer are stacked.

The touch sensor layer 150 may be disposed on the encapsulation layer 140.

According to the embodiment of FIG. 4, the touch sensor layer 150 may be disposed on the third encapsulation layer 143 of the encapsulation layer 140.

The touch sensor layer 150 may include a third buffer layer 151 disposed on the encapsulation layer 140, the bridge electrode BE disposed on the third buffer layer 151, a sensor insulating layer 152 covering the bridge electrode BE, the driving electrode TE and the sensing electrode RE disposed on the sensor insulating layer 152, and an overcoat layer 153 covering the driving electrode TE and the sensing electrode RE.

Each of the third buffer layer 151 and the sensor insulating layer 152 may have a structure in which one or more inorganic layers of a silicon nitride layer, a silicon oxynitride layer, a silicon oxide layer, a titanium oxide layer, and an aluminum oxide layer are stacked.

The overcoat layer 153 may be made of an organic material that can be disposed in a low-temperature process. In an embodiment, for example, the overcoat layer 153 may be made of a negative photoresist material.

Each of the bridge electrode BE, the driving electrode TE, and the sensing electrode RE may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

Each of the dummy electrode DE disposed inside each of the driving electrode TE and the sensing electrode RE, the first driving line TL1 and the second driving line TL2 connected to the driving electrode TE, and the sensing line RL connected to the sensing electrode RE may be disposed on the same layer as the driving electrode TE and the sensing electrode RE.

The driving electrode TE may be electrically connected to the bridge electrode BE through the touch contact hole TCNT1 penetrating the sensor insulating layer 152.

The driving electrode TE, the sensing electrode RE, the dummy electrode DE, the first driving line TL1 and the second driving line TL2, and the sensing line RL may have a structure including a low reflective layer. In this way, the amount of light that is incident from the outside, reflected within the display panel 100, and emitted (i.e., the reflection of external light) may be reduced.

The polarization layer 160 may be disposed on the overcoat layer 153 of the touch sensor layer 150.

Alternatively, the display panel 100 of the display device 10 according to one embodiment may further include an adhesive layer 161 disposed between the polarization layer 160 and the overcoat layer 153. That is, the polarization layer 160 may be attached on the overcoat layer 153 through the adhesive layer 161 on the overcoat layer 153.

FIG. 10 is a layout diagram illustrating part C of FIG. 4. FIG. 11 is a cross-sectional view taken along line F-F' of FIG. 10.

Referring to FIG. 10, the circuit layer 120 of the display panel 100 of the display device 10 according to one embodiment may include the data lines DL for transmitting the data signal Vdata to the pixel drivers PXD, and data connection lines DCNL disposed in the non-display area NDA, electrically connected to the data lines DL, respectively, and extending to the first sub-region SB1.

The data connection lines DCNL extend to the dam area DMA and the junction area JNA, and thus may be included in the first conductive layer or the second conductive layer disposed under the third insulating layer 125.

According to one embodiment, the circuit layer 120 may further include data bending lines DBDL disposed in the bending area BA, electrically connected to the data connection lines DCNL, respectively, and extending to the second sub-region SB2.

Further, the circuit layer 120 may further include data pad lines DPDL disposed in the second sub-region SB2 and electrically connected to the data bending lines DBDL, respectively. The data pad lines DPDL may be electrically connected to output terminals (not illustrated) of the display driving circuit 200, respectively.

Accordingly, the data lines DL may be electrically connected to the output terminals of the display driving circuit 200 through the data pad lines DPDL, the data bending lines DBDL, and the data connection lines DCNL, respectively.

As illustrated in FIG. 11, the non-display area NDA may further include a dam isolation area DISA between the display area DA and the dam area DMA.

The circuit layer 120 may further include a first power supply line VDSPL and a second power supply line VSSPL disposed in the dam isolation area DISA (see FIG. 11) of the non-display area NDA and for transmitting the first power ELVDD and the second power ELVSS, respectively.

The first power supply line VDSPL may include a first power main line VDSPL 1 made of a part of the fourth conductive layer and a first power sub-line VDSPL2 made of a part of the third conductive layer.

Similarly, the second power supply line VSSPL may include a second power main line VSSPL1 made of a part of the fourth conductive layer and a second power sub-line VSSPL2 made of a part of the third conductive layer.

The second power main line VSSPL1 may extend to the dam area DMA.

The circuit layer 120 may include a first power connection line VDCNL disposed in the dam area DMA and the junction area JNA, electrically connected to the first power supply line VDSPL, and extending to the first sub-region SB1, a first power bending line VDBDL disposed in the bending area BA and electrically connected to the first power connection line VDCNL, and a first power pad line VDPDL disposed in the second sub-region SB2, electrically connected to the first power bending line VDBDL, and extending to one of the signal pads SPD. Accordingly, the first power supply line VDSPL may be electrically connected to the circuit board 300 through one of the first power connection line VDCNL, the first power bending line VDBDL, the first power pad line VDPDL, and the signal pads SPD.

In addition, the circuit layer 120 may further include a second power connection line VSCNL disposed in the dam area DMA and junction area JNA, electrically connected to the second power supply line VSSPL, and extending to the first sub-region SB1, a second power bending line VSBDL disposed in the bending area BA and electrically connected to the second power connection line VSCNL, and a second power pad line VSPDL disposed in the second sub-region SB2, electrically connected to the second power bending line VSBDL, and extending to another one of the signal pads SPD. Accordingly, the second power supply line VSSPL may be electrically connected to the circuit board 300 through the other one of the second power connection line VSCNL, the second power bending line VSBDL, the second power pad line VSPDL, and the signal pads SPD.

Referring to FIG. 11, the first conductive layer on the first insulating layer 123 may further include some of the data connection lines DCNL in the non-display area NDA.

The second conductive layer on the second insulating layer 124 may further include the remaining others of the data connection lines DCNL in the non-display area NDA.

The first conductive layer on the first insulating layer 123 or the second conductive layer on the second insulating layer 124 may further include the data pad line DPDL of the second sub-region SB2.

The third conductive layer on the third insulating layer 125 may include the first power sub-line VDSPL2 and the second power sub-line VSSPL2 in the non-display area NDA.

The fourth conductive layer on the fourth insulating layer 126 may include the data line DL of the display area DA, the first power main line VDSPL1 and the second power main line VSSPL1 of the non-display area NDA, and the data bending line DBDL of the bending area BA.

The second power main line VSSPL1 may extend to the dam area DMA and overlap the at least one dam portion DAM in a plan view.

At least one dam portion DAM is arranged in the dam area DMA, and each of the at least one dam portion DAM may include a structure in which two or more dam layers are stacked.

Each of the two or more dam layers may be formed of an organic layer. That is, each of the two or more dam layers may be the same layer as one of the fourth insulating layer 126, the fifth insulating layer 127, the pixel defining layer 132, and a spacer layer (not illustrated).

In an embodiment, for example, the dam area DMA may include a first dam portion DAM1 and a second dam portion DAM2 disposed between the first dam portion DAM1 and the display area DA.

The first dam portion DAM1 may include a structure in which three dam layers DML11, DML12, and DML13 are stacked. In the first dam portion DML1, the first dam layer DML11 may be a part of the fifth insulating layer 127, the second dam layer DML12 may be the same layer as the pixel defining layer 132, and the third dam layer DML13 may be the same layer as the spacer layer.

The second dam portion DAM2 may include a structure in which two dam layers DML21 and DML22 are stacked. In the second dam portion DAM2, the first dam layer DML21 may be the same layer as the pixel defining layer 132, and the second dam layer DML22 may be the same layer as the spacer layer.

Here, the pixel defining layer 132 and the spacer layer may be provided together through a mask process using a halftone mask.

The at least one dam portion DAM disposed in the dam area DMA is spaced apart from the display area DA, and thus the organic layers 126, 127, and 132 between the dam area DMA and the display area DA and between the dam portions DAM may be removed to generate a valley.

In addition, also in the junction area JNA disposed around the dam area DMA, the organic layers 126, 127, and 132 may be removed to expose the third insulating layer 125.

Accordingly, in the junction area JNA, the first encapsulation layer 141 of the encapsulation layer 140 may be bonded onto the third insulating layer 125 of the circuit layer 120.

Further, the second encapsulation layer 142 of the encapsulation layer 140 is disposed in the area surrounded by the dam portion DAM of the dam area DMA, and thus in the junction area JNA, the third encapsulation layer 143 of the encapsulation layer 140 may be bonded onto the first encapsulation layer 141.

Accordingly, an encapsulation structure including bonding of inorganic materials may be provided in the junction area JNA.

Meanwhile, when the bending area BA is bendable, cracks may be generated in inorganic layers that are relatively vulnerable to bending stress.

To prevent this, the display panel 100 of the display device 10 according to one embodiment may further include a bending hole BDH disposed in the bending area BA and penetrating the first insulating layer 123, the second insulating layer 124, and the third insulating layer 125, and a bank BNK covering the bending hole BDH.

The bending hole BDH may penetrate all of the inorganic layers disposed on the substrate 110 in the bending area BA. That is, the bending hole BDH may further penetrate the first buffer layer 121 and the second buffer layer 122.

The bank BNK is to cover the bending hole BDH and protect the data bending lines DBDL of the bending area BA.

The bank BNK may include a structure in which bank layers made of organic layers are stacked.

That is, the bank BNK may include a first bank layer BNL1 that is a part of the fourth insulating layer 126 and covers the bending hole BDH, a second bank layer BNL2 that is a part of the fifth insulating layer 127 and covers the first bank layer BNL1, a third bank layer BNL3 that is the same layer as the pixel defining layer 132 and disposed on the second bank layer BNL2, and a fourth bank layer BNL4 that is the same layer as the spacer layer and disposed on the third bank layer BNL3.

The data bending lines DBDL of the bending area BA are included in the fourth conductive layer, and thus may be covered with the second bank layer BNL2 that is a part of the fifth insulating layer 127.

According to one embodiment, the polarization layer 160 of the display device 10 may not only overlap the light emitting element layer 130 of the display area DA, but also extend into the non-display area NDA to overlap the junction area JNA of the non-display area NDA.

In another embodiment, for example, in order to be more firmly attached, the polarization layer 160 may extend to the sub-region SBA to cover a part of the bank BNK.

As the polarization layer 160 is attached by a laminating method using a high pressure, during the disposition process of the polarization layer 160, the first conductive layer, the second conductive layer, and the insulating layers of the inorganic insulating material may be damaged in the junction area JNA from which the insulating layers of the organic insulating material are removed.

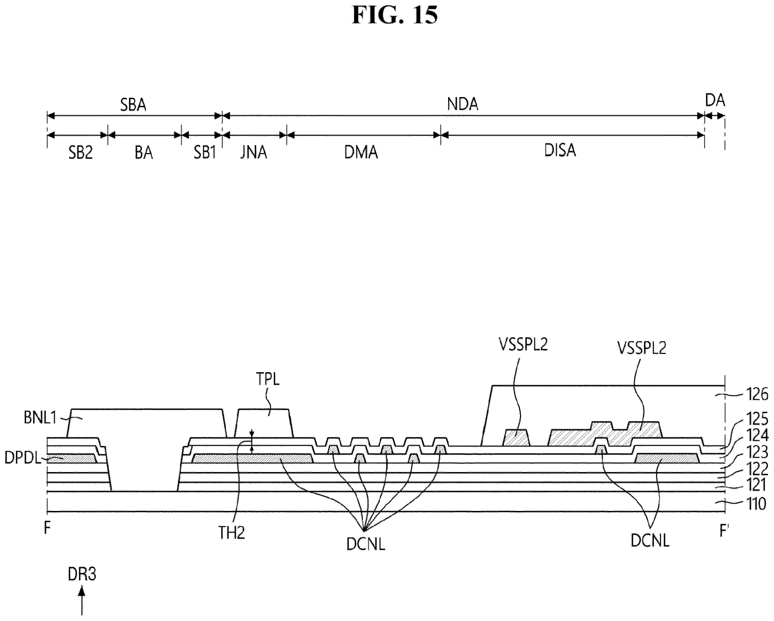

However, as will be described later, in a method for manufacturing a display device according to one embodiment, after disposing a temporary protective layer TPL (see FIG. 15) on the third insulating layer 125 of the junction area JNA, the step of disposing the fourth conductive layer is included.

Accordingly, according to one embodiment, a thickness TH2 of the third insulating layer 125 at the central point of the junction area JNA may be maintained substantially the same as a thickness TH1 (see FIG. 9) of the third insulating layer 125 in the display area DA, where the central point may be measured with respect to a direction (i.e., the second direction DR2) from the sub-region SBA to the main region MA.

As such, the thickness TH2 of the third insulating layer 125 in the junction area JNA is maintained substantially the same as the thickness TH1 (see FIG. 9) of the third insulating layer 125 in the display area DA, so that resistance to a high pressure during the disposition of the polarization layer 160 may be maintained. Accordingly, although the polarization layer 160 extends into the junction area JNA, the first conductive layer, the second conductive layer, and the insulating layers of the inorganic insulating material may be prevented from being damaged in the junction area JNA. As a result, quality reliability and lifespan of the display device 10 may be improved.

Next, a method for manufacturing a display device according to the embodiment of FIG. 4 will be described.

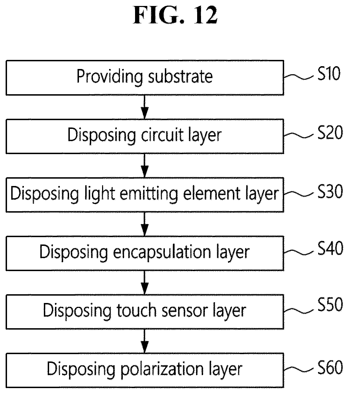

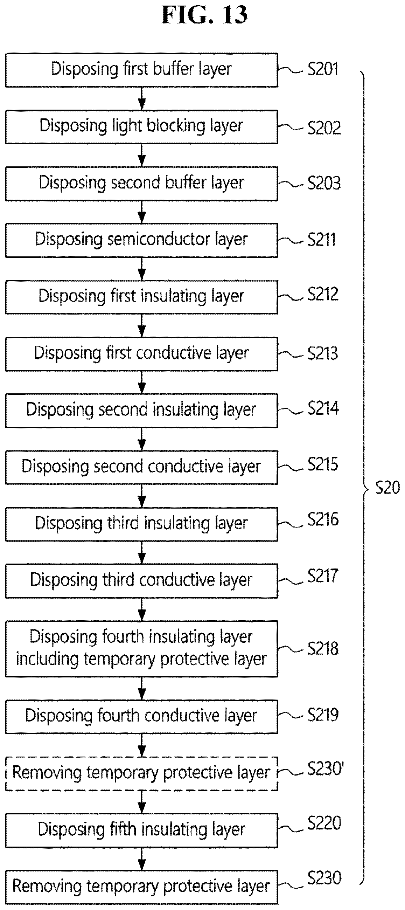

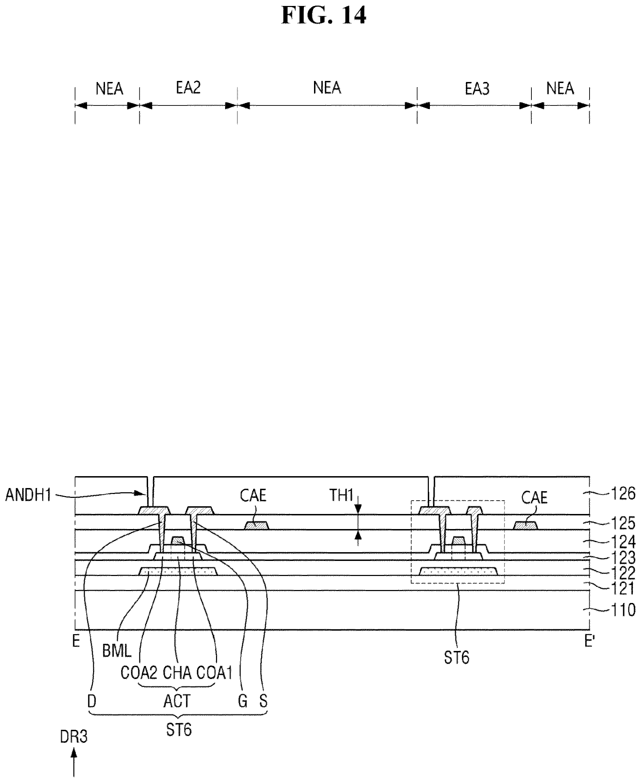

FIG. 12 is a flowchart illustrating a method for manufacturing the display device according to the embodiment of FIG. 4. FIG. 13 is a flowchart illustrating the steps of disposing the circuit layers of FIG. 12. FIGS. 14, 15, 16, 17, 18, 19, 20, 21, 22, 23, 24, 25, and 26 are process diagrams illustrating some steps of FIGS. 12 and 13.

Referring to FIG. 12, the manufacturing method of the display device 10 according to the embodiment of FIG. 4 includes providing the substrate 110 including the main region MA including the display area DA in which the emission areas EA are arranged and the non-display area NDA disposed around the display area DA and the sub-region SBA protruding from one side of the main region (step S10), and disposing the circuit layer 120 including the pixel drivers PXD corresponding to the emission areas EA, respectively, on the substrate 110 (step S20).

In step S10 of providing the substrate 110, the non-display area NDA of the substrate 110 includes the dam area DMA in which at least one dam portion DAM spaced apart from the display area DA and surrounding the display area DA is disposed, and the junction area JNA surrounding the dam area DMA.

Further, the manufacturing method of the display device 10 according to the embodiment of FIG. 4 may further include disposing the light emitting element layer 130 on the circuit layer 120 (step S30), disposing the encapsulation layer 140 on the light emitting element layer 130 (step S40), disposing the touch sensor layer 150 on the encapsulation layer 140 (step S50), and disposing the polarization layer 160 overlapping the light emitting element layer 130 on the touch sensor layer 150 in a plan view (step S60).

Referring to FIG. 13, step S20 of disposing the circuit layer 120 according to the embodiment of FIG. 4 includes disposing the semiconductor layer ACT on the substrate 110 (step S211), disposing the first insulating layer 123 covering the semiconductor layer ACT on the substrate 110 (step S212), disposing the first conductive layer G on the first insulating layer 123 (step S213), disposing the second insulating layer 124 covering the first conductive layer G on the first insulating layer 123 (step S214), disposing the second conductive layer CAE on the second insulating layer 124 (step S215), disposing the third insulating layer 125 covering the second conductive layer CAE on the second insulating layer 124 (step S216), disposing the third conductive layers S and D on the third insulating layer 125 (step S217), disposing the fourth insulating layer 126 covering the third conductive layers S and D on the third insulating layer 125 (step S218), disposing the fourth conductive layer ANDE on the fourth insulating layer 126 (step S219), and disposing the fifth insulating layer 127 covering the fourth conductive layer ANDE on the fourth insulating layer 126 (step S220).

In step S218 of disposing of the fourth insulating layer 126, the fourth insulating layer 126 includes the first planarization layer disposed in the display area DA, and the temporary protective layer TPL (see FIG. 15) disposed in at least a part of the junction area JNA and spaced apart from the dam area DMA and the sub-region SBA.

Further, in accordance with the embodiment of FIG. 4, step S20 of disposing the circuit layer 120 further includes removing the temporary protective layer TPL (step S230 or S230') after step S219 of disposing the fourth conductive layer ANDE.

In accordance with the embodiment of FIG. 4, step S230 of removing the temporary protective layer TPL may be performed after step S220 of disposing the fifth insulating layer 127.

Alternatively, in accordance with the embodiment of FIG. 4, step S230' of removing the temporary protective layer TPL may be performed before step S220 of disposing the fifth insulating layer 127.

Referring to FIGS. 14 and 15, in step S10 of providing the substrate 110, the substrate 110 includes the main region MA and the sub-region SBA.

The main region MA includes the display area DA and the non-display area NDA.

The emission areas EA are arranged in the display area DA.

The non-display area NDA includes the dam area DMA and the junction area JNA. In addition, the non-display area NDA may further include the dam isolation area DISA between the display area DA and the dam area DMA.

The sub-region SBA may include a bending area BA that is bendable, and a first sub-region SB1 and the second sub-region SB2 that are in contact with opposite sides of the bending area BA, respectively.

Step S20 of disposing of the circuit layer 120 may further include, before step S211 of disposing the semiconductor layer ACT, disposing the first buffer layer 121 on the substrate 110 (step S201), disposing the light blocking layer BML overlapping at least a part of the semiconductor layer ACT on the buffer layer 121 in a plan view (step S202), and disposing the second buffer layer 122 covering the light blocking layer BML on the first buffer layer 121 (step S203).

In step S211 of disposing the semiconductor layer ACT, the semiconductor layer ACT may be disposed on the second buffer layer 122.

The semiconductor layer ACT may include the active layers ACT of the transistors DT and ST1 to ST6.

In step S212 of disposing the first insulating layer 123, the first insulating layer 123 may cover the semiconductor layer ACT and include an inorganic insulating material.

In step S213 of disposing the first conductive layer G, the first conductive layer G may include the gate electrodes G of the transistors DT and ST1 to ST6.

The first conductive layer on the first insulating layer 123 may further include some data connection lines DCNL among the data connection lines DCNL disposed in the non-display area NDA and electrically connected to the data lines DL.

In step S214 of disposing the second insulating layer 124, the second insulating layer 124 may cover the first conductive layer G and include an inorganic insulating material.

In step S215 of disposing the second conductive layer CAE, the second conductive layer CAE may include the first capacitor electrode CAE of the capacitor PC1.

The second conductive layer on the second insulating layer 124 may further include the other data connection lines DCNL among the data connection lines DCNL disposed in the non-display area NDA.

The first conductive layer or the second conductive layer may further include the data pad lines DPDL disposed in the second sub-region SB2.

In step S216 of disposing the third insulating layer 125, the third insulating layer 125 may cover the second conductive layer CAE and include an inorganic insulating material.

After step S216 of disposing the third insulating layer 125, the bending hole BDH correspond to the bending area BA and penetrating the first buffer layer 121, the second buffer layer 122, the first insulating layer 123, and the second insulating layer 124, and the third insulating layer 125 may be provided.

The bending hole BDH may be provided together with connection holes for electrical connection between each of the source electrode, which may be defined by the third conductive layer S, and the drain electrode, which may be defined by the third conductive layer D, and the active layer ACT.

In step S217 of disposing the third conductive layers S and D, the third conductive layers S and D may include the source electrodes of the transistors DT and ST1 to ST6, and the drain transistors of the transistors DT and ST1 to ST6.

The third conductive layer on the third insulating layer 125 may further include the first power sub-line VDSPL2 and the second power sub-line VSSPL2 disposed in the non-display area NDA.

In step S218 of disposing the fourth insulating layer 126, the fourth insulating layer 126 may cover the third conductive layers S, D, VDSPL2 and VSSPL2 and include an organic insulating material.

The fourth insulating layer 126 includes the first planarization layer disposed in the display area DA, and the temporary protective layer TPL disposed in the junction area JNA. The temporary protective layer TPL is spaced apart from each of the dam area DMA and the sub-region SBA.

As illustrated in FIG. 15, the temporary protective layer TPL may be disposed in the entire junction area JNA.

Alternatively, although not separately shown, the temporary protective layer TPL may be disposed only in a part of the junction area JNA where the damage to the inorganic layers increases due to a relatively large pressure of a roller. That is, the temporary protective layer TPL may be disposed only in a part of the junction area JNA that is adjacent to the first sub-region SB1.

In addition, the fourth insulating layer 126 may further include the first bank layer BNL1 covering the bending hole BDH of the bending area BA.

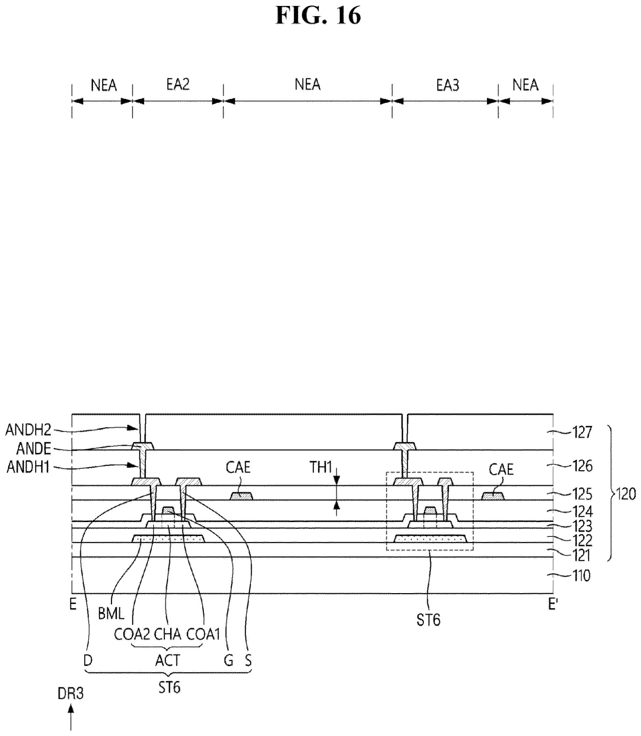

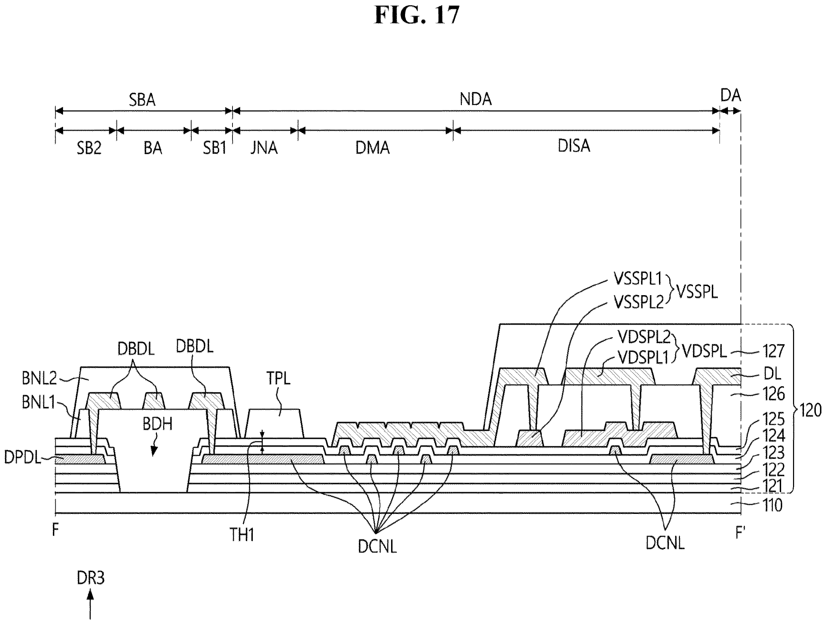

Referring to FIGS. 16 and 17, in step S219 of disposing the fourth conductive layer ANDE, the fourth conductive layer ANDE includes the anode connection electrodes ANDE corresponding to the emission areas EA, respectively.

In addition, the fourth conductive layer on the fourth insulating layer 126 may further include the first power main line VDSPL1 and the second power main line VSSPL1 disposed in the non-display area NDA, and the data bending lines DBDL disposed in the bending area BA.

The second power main line VSSPL1 may extend to the dam area DMA to be in contact with the third insulating layer 125 in the dam area DMA and overlap some of the data connection lines DCNL in a plan view.

In step S220 of disposing the fifth insulating layer 127, the fifth insulating layer 127 may cover the fourth conductive layers ANDE, VDSPL1, VSSPL1, and DBDL and include an organic insulating material.

The fifth insulating layer 127 includes the second planarization layer disposed in the display area DA and covering the first planarization layer of the fourth insulating layer 126.

In addition, the fifth insulating layer 127 may further include the first dam layer DML11 of the first dam portion DAM1 disposed in the dam area DMA, and the second bank layer BNL2 disposed in the dam area DMA and covering the first bank layer BNL1.

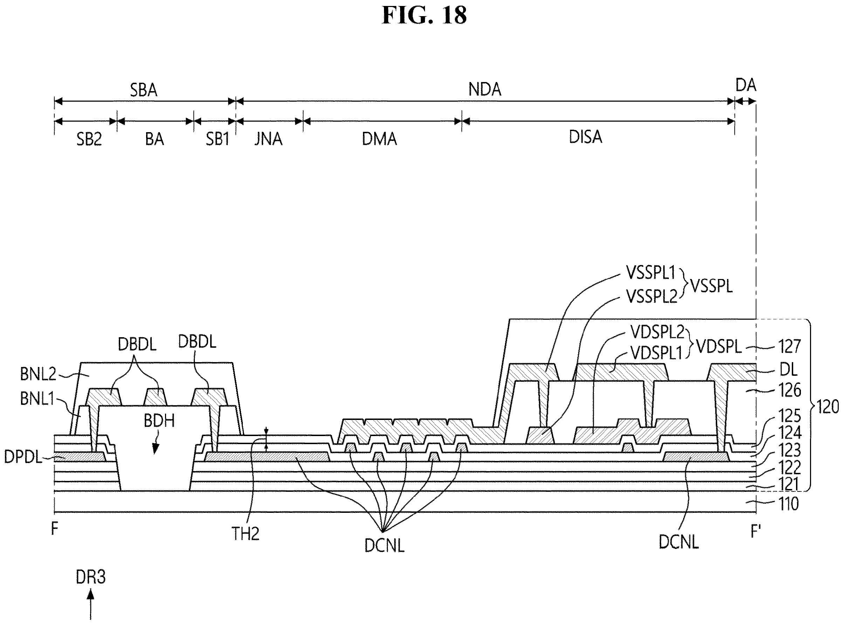

Next, as shown in FIG. 18, by performing step S230 of removing the temporary protective layer TPL, or although not separately shown, by performing step S220 of disposing the fifth insulating layer 127 after step S230' of removing the temporary protective layer TPL, step S20 of disposing the circuit layer 120 may be completed.

Since the third insulating layer 125 of the junction area JNA is covered with the temporary protective layer TPL while step S219 of disposing the fourth conductive layer ANDE is being performed, the thickness of the third insulating layer 125 of the junction area JNA may not be reduced similarly to the third insulating layer 125 of the display area DA.

Accordingly, after step S230 or S230' of removing the temporary protective layer TPL, with respect to the direction in which the display area DA and the sub-region SBA face each other (i.e., the second direction DR2), the thickness TH2 of the third insulating layer 125 at the central point of the junction area JNA may be maintained substantially the same as the thickness TH1 of the third insulating layer 125 in the display area DA.

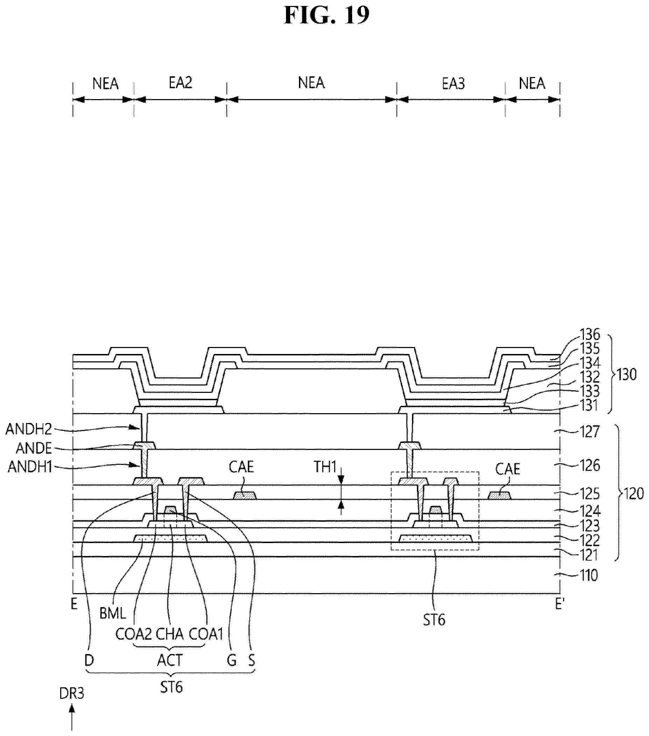

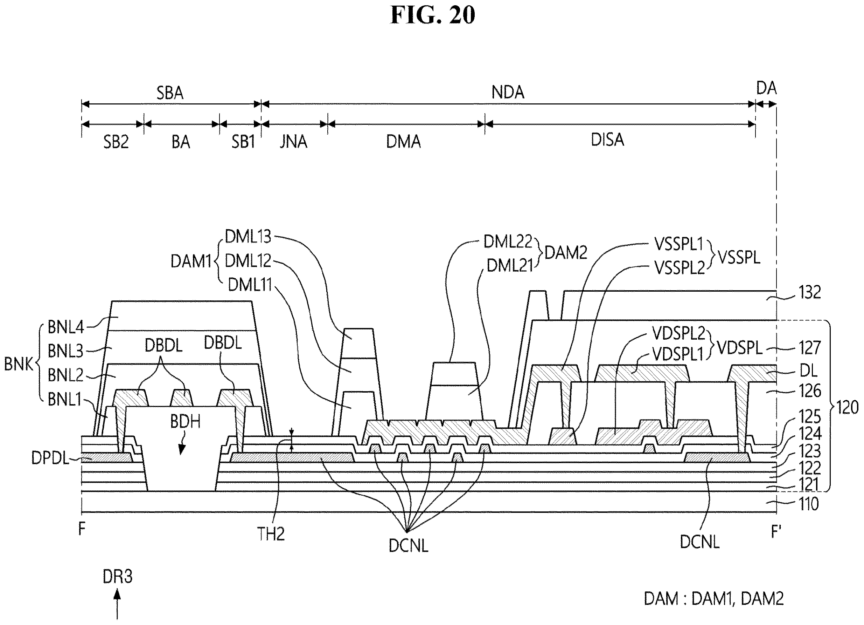

Next, referring to FIGS. 19 and 20, in step S30 of disposing the light emitting element layer 130 on the circuit layer 120, the light emitting element layer 130 may include the anode electrodes 131 disposed on the fifth insulating layer 127 of the circuit layer 120 and corresponding to the emission areas EA, respectively, the pixel defining layer 132 disposed on the fifth insulating layer 127 of the circuit layer 120, corresponding to the non-emission area NEA, which is a separation area between the emission areas EA, and covering the edge of each of the anode electrodes 131, the spacer layer (not illustrated) disposed on a part of the pixel defining layer 132, the first common layers 133 disposed on the anode electrodes 131, respectively, the light emitting layers 134 disposed on the first common layers 133, respectively, the second common layer 135 disposed on the pixel defining layer 132, the spacer layer, and the light emitting layer 134, and the cathode electrode 136 disposed on the second common layer 135.

As shown in FIG. 20, in step S30 of disposing the light emitting element layer 130, the second dam layer DML12 of the first dam portion DAM1 and the first dam layer DML21 of the second dam portion DAM2 disposed in the dam area DMA, and the third bank layer BNL3 disposed in the bending area BA and covering the second bank layer BNL2 may be provided together with the pixel defining layer 132.

In addition, in step S30 of disposing the light emitting element layer 130, the third dam layer DML13 of the first dam portion DAM1 and the second dam layer DAM22 of the second dam portion DAM2 disposed in the dam area DMA, and the fourth bank layer BNL4 disposed on the third bank layer BNL3 of the bending area BA may be provided together with the spacer layer.

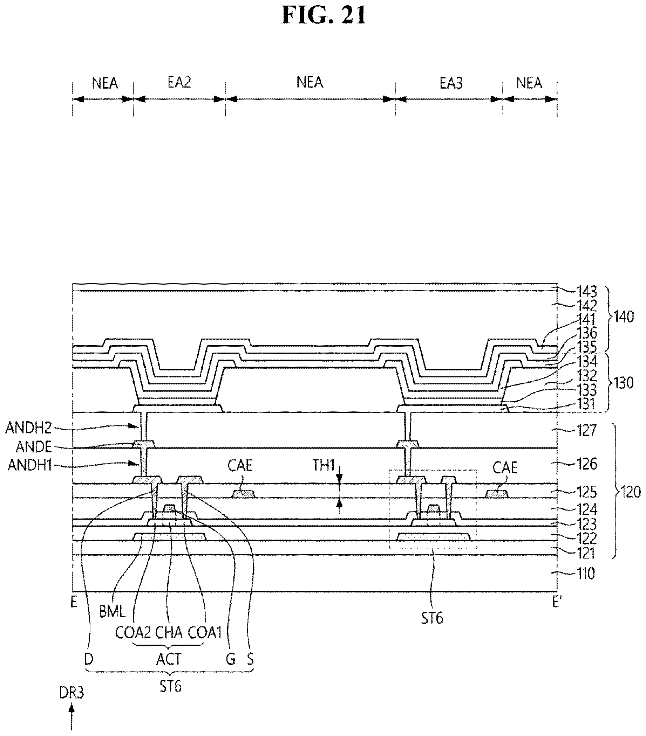

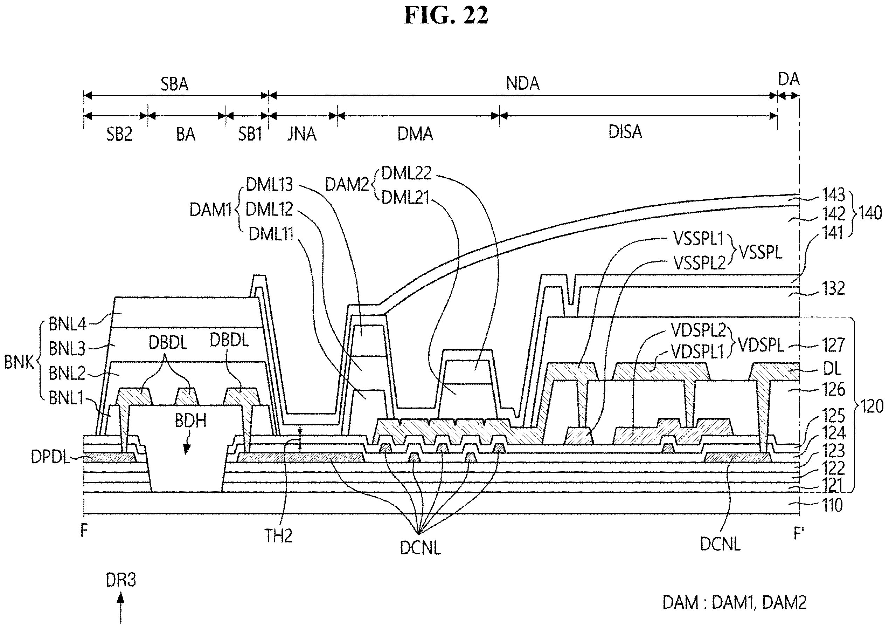

Referring to FIGS. 21 and 22, in step S40 of disposing the encapsulation layer 140, the encapsulation layer 140 may include the first encapsulation layer 141 disposed on the circuit layer 120, covering the light emitting element layer 130, and including an inorganic insulating material, the second encapsulation layer 142 disposed on the first encapsulation layer 141, overlapping the light emitting element layer 130 in a plan view, and including an organic insulating material, and the third encapsulation layer 143 disposed on the first encapsulation layer 141, covering the second encapsulation layer 142, and including an inorganic insulating material.

As shown in FIG. 22, the second encapsulation layer 142 may be provided by dropping a liquid-type organic material on the first encapsulation layer 141, diffusing it in the area surrounded by at least one dam portion DAM, and then curing it. Accordingly, the second encapsulation layer 142 may be disposed in the area surrounded by at least one dam portion DAM.

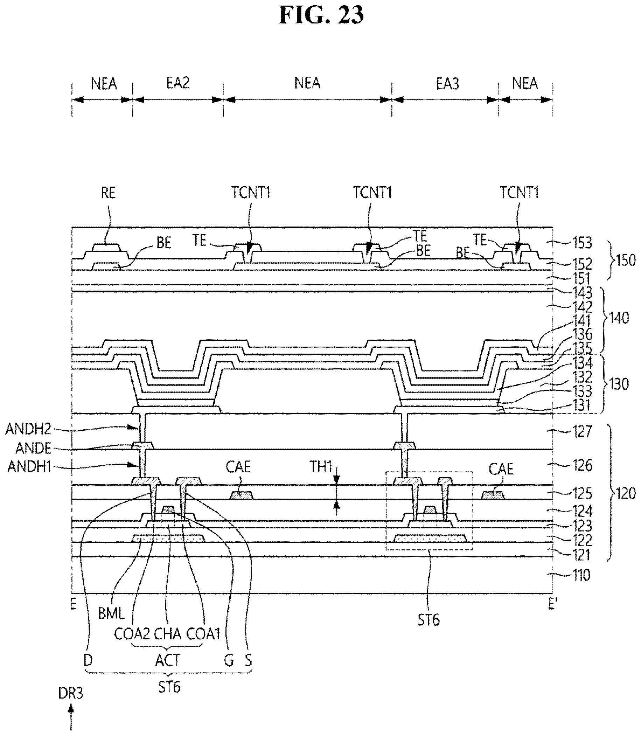

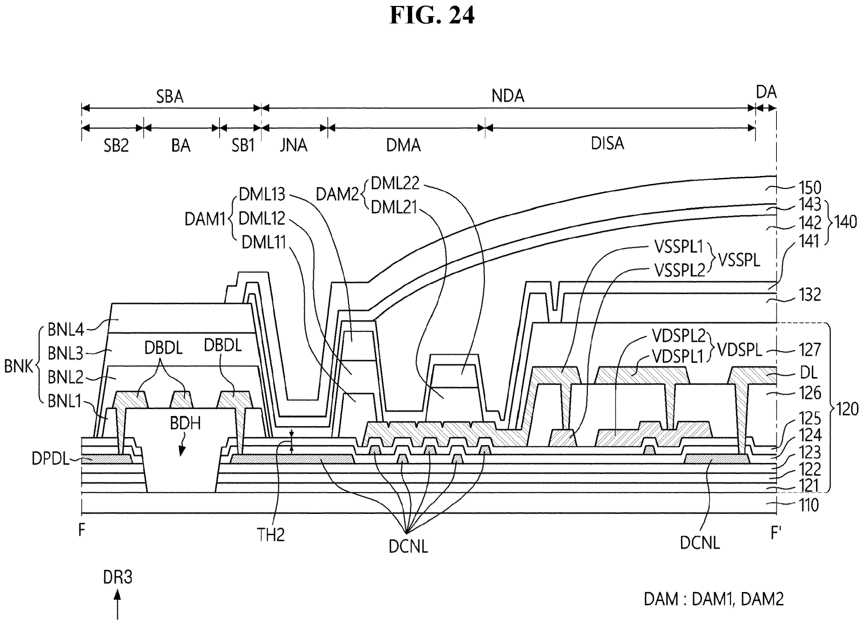

Referring to FIGS. 23 and 24, in step S50 of disposing the touch sensor layer 150 on the encapsulation layer 140, the touch sensor layer 150 may include the third buffer layer 151 disposed on the encapsulation layer 140, the bridge electrode BE disposed on the third buffer layer 151, the sensor insulating layer 152 covering the bridge electrode BE, the driving electrode TE and the sensing electrode RE disposed on the sensor insulating layer 152, and the overcoat layer 153 covering the driving electrode TE and the sensing electrode RE.

Among the third buffer layer 151, the sensor insulating layer 152, and the overcoat layer 153 of the touch sensor layer 150, at least the overcoat layer 153 may extend to the sub-region SBA to cover a part of the bank BNK of the bending area BA that extends to the first sub-region SB1.

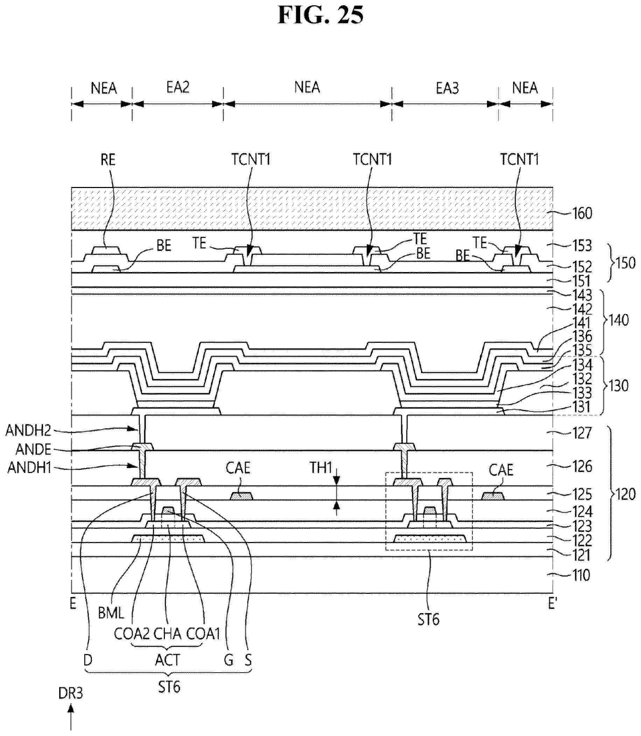

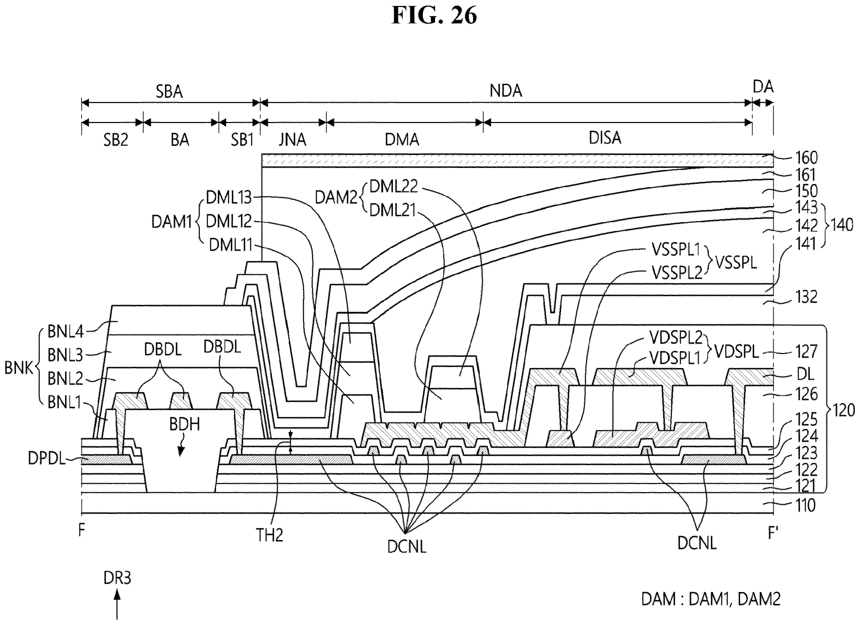

Referring to FIGS. 25 and 26, in step S60 of disposing the polarization layer 160 on the touch sensor layer 150, the polarization layer 160 may overlap the light emitting element layer 130 in a plan view.

The polarization layer 160 may be attached on the touch sensor layer 150 by the adhesive layer 161.

Further, the polarization layer 160 may extend to the non-display area NDA and overlap the junction area JNA. That is, in the junction area JNA, the polarization layer 160 may overlap some of the data connection lines DCNL in a plan view.

In step S60 of disposing the polarization layer 160, the polarization layer 160 may be attached on the touch sensor layer 150 by a laminating method using a high pressure.

In this case, with respect to the direction in which the display area DA and the sub-region SBA face each other (i.e., the second direction DR2), the thickness TH2 of the third insulating layer 125 at the central point of the junction area JNA is maintained substantially the same as the thickness TH1 of the third insulating layer 125 in the display area DA, the third insulating layer 125 may not be easily damaged even if a high pressure of the laminating method is applied. Accordingly, the first conductive layer or the second conductive layer in the junction area JNA may be prevented from being easily damaged, which makes it possible to improve the quality reliability and lifespan of the display device 10.

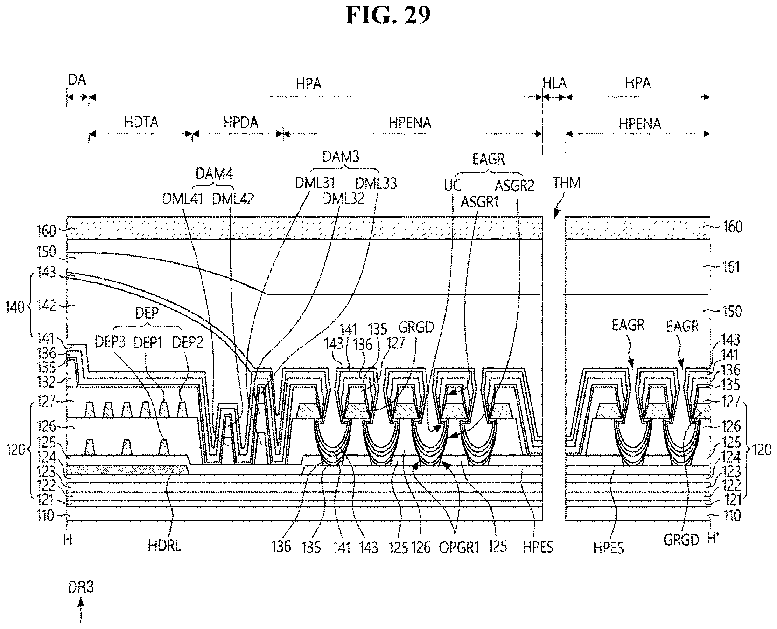

Meanwhile, the display device 10 may further include a through portion THM (see FIG. 29) for inserting a functional module into the display panel 100.

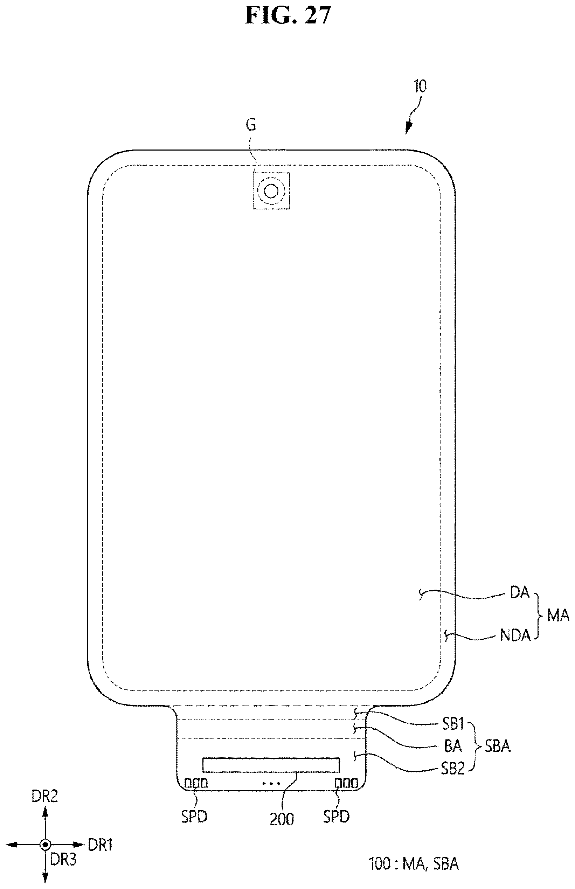

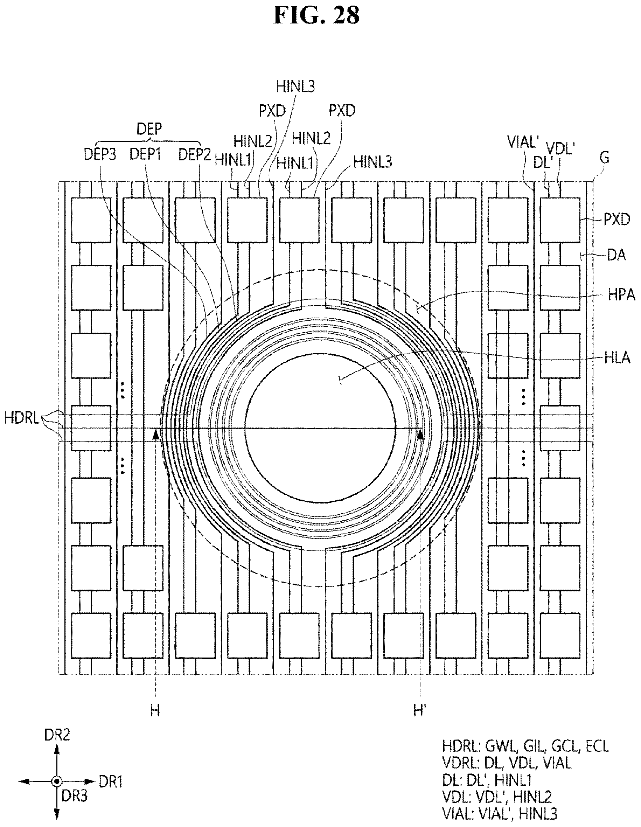

FIG. 27 is a plan view illustrating a main region and a sub-region of a display device according to another embodiment. FIG. 28 is a layout diagram illustrating part G of FIG. 27. FIG. 29 is a cross-sectional view taken along line H-H' of FIG. 28.

Referring to FIGs. 27 to 29, the substrate 110 of the display panel 100 of the display device 10 according to the another embodiment may further include a hole area HLA surrounded by the main region MA, and a hole periphery area HPA between the main region MA and the hole area HLA.

The display device 10 according to the embodiment of FIG. 27 may further include a through hole THH (see FIG. 29) disposed in the hole area HLA. The through portion THM may penetrate at least the substrate 110 of the display panel 100. In an embodiment, for example, the through portion THM may penetrate a part of each of the substrate 110, the circuit layer 120, the light emitting element layer 130, the encapsulation layer 140, the touch sensor layer 150, and the polarization layer 160 that are disposed in the hole area HLA.

The through portion THM may overlap at least a part of a functional module (not shown) disposed outside the display panel 100 in a plan view, and may be provided as a path for inputting sensing information of the functional module or a path for outputting sound of the functional module.

In an embodiment, for example, the functional module may be disposed under the display panel 100 to overlap the through portion THM in a plan view, or may be disposed in the through portion THM.

In an embodiment, for example, the functional module may include a camera module for imaging or recognizing an image corresponding to the front surface of the display device 10, a face recognition sensor module for detecting a user's face, a pupil recognition sensor module for detecting a user's pupil, an acceleration sensor module and a geomagnetic sensor module for determining the movement of the display device, a proximity sensor module and an infrared sensor module for detecting whether the front surface of the display device 10 is close, and an illuminance sensor module for measuring a degree of external brightness, or the like.

Referring to FIG. 28, the circuit layer 120 may include first direction lines HDRL disposed in the display area DA and extending in the first direction DR1, and second direction lines VDRL disposed in the display area DA and extending in the second direction DR2.

The first direction lines HDRL may include lines electrically connected to the gate electrodes of some of the transistors DT and ST1 to ST6 of the pixel drivers PXD. In an embodiment, for example, the first direction lines HDRL may include the scan write line GWL that transmits the scan write signal GW to the pixel driver PXD, the scan initialization line GIL that transmits the scan initialization signal GI to the pixel driver PXD, the emission control line ECL that transmits the emission control signal EM to the pixel driver PXD, and the gate control line GCL that transmits the gate control signal GC to the pixel driver PXD.

The second direction lines VDRL may include lines electrically connected to source electrodes or drain electrodes of some others of the transistors DT and ST1 to ST6 of the pixel drivers PXD. In an embodiment, for example, the second direction lines VDRL may include the data line DL configured to transmit the data signal Vdata to the pixel drivers PXD, the first power line VDL configured to transmit the first power ELVDD to the pixel drivers PXD, and an initialization voltage auxiliary line VIAL configured to transmit the initialization voltage Vint to the pixel drivers PXD.

The display device 10 according to the embodiment of FIG. 27 includes the through portion THM corresponding to the hole area HLA, and the through portion THM penetrates the circuit layer 120 and the light emitting element layer 130, so that the hole area HLA and the hole periphery area HPA disposed around the hole area HLA become the non-display area.

The hole periphery area HPA may include a hole periphery encapsulation area HPENA for encapsulating the periphery of the hole area HLA, a hole periphery dam area HPDA for preventing the second encapsulation layer 142 from being diffused to the hole area HLA, and a hole periphery bypass area HDTA for disposing bypass portions of lines intersecting the hole area HLA.

The hole periphery encapsulation area HPENA may be disposed around the hole area HLA. One or more encapsulation auxiliary grooves EAGR surrounding the periphery of the hole area HLA may be arranged in the hole periphery encapsulation area HPENA.

Each of the one or more encapsulation auxiliary grooves EAGR may penetrate the fourth insulating layer 126 and the fifth insulating layer 127, each including an organic insulating material. Each of the one or more encapsulation auxiliary grooves EAGR may expose the third insulating layer 125 made of an inorganic insulating material, and may include an undercut structure for separating the second common layer 135 and the cathode electrode 136.

The hole periphery dam area HPDA may be disposed around the hole periphery encapsulation area HPENA. One or more auxiliary dam portions DAM3 and DAM4 surrounding the periphery of the hole periphery encapsulation area HPENA may be arranged in the hole periphery dam area HPDA.

The hole periphery bypass area HDTA may be disposed between the hole periphery dam area HPDA and the main region MA. The hole periphery bypass area HDTA may be spaced apart from the pixel defining layer 132 and the spacer layer. The bypass portions of the lines intersecting the hole area HLA may be arranged in the hole periphery bypass area HDTA.

Some of the first direction lines HDRL may intersect the hole area HLA and the hole periphery area HPA, and may include first direction bypass portions of the hole periphery bypass area HDTA.

The second direction lines VDRL may include hole intersection lines HINL intersecting the hole area HLA and the hole periphery area HPA. Each of the hole intersection lines HINL may include a bypass portion DEP that is disposed in the hole periphery bypass area HDTA and bypasses along the periphery of the hole area HLA.

That is, the data lines DL may include first hole intersection lines HINL1 intersecting the hole area HLA and the hole periphery area HPA, and the other general data lines DL' extending between opposite ends of the display area DA in the second direction DR2.

The first power lines VDL may include second hole intersection lines HINL2 intersecting the hole area HLA and the hole periphery area HPA, and the other general first power lines VDL' extending between opposite ends of the display area DA in the second direction DR2.

Further, the initialization voltage auxiliary lines VIAL may include third hole intersection lines HINL3 intersecting the hole area HLA and the hole periphery area HPA, and the other general initialization voltage auxiliary lines VIAL' extending between opposite ends of the display area DA in the second direction DR2.

The bypass portions DEP of the hole periphery bypass area HDTA may include a first bypass portion DEP1 electrically connected to each of the first hole intersection lines HINL1 that are some of the data lines DL, a second bypass portion DEP2 electrically connected to each of the second hole intersection lines HNL2 that are some of the first power lines VDL, and a third bypass portion DEP3 electrically connected to each of the third hole intersection lines HINL3 that are some of the initialization voltage auxiliary lines VIAL.

Referring to FIG. 29, the circuit layer 120 of the display panel 100 of the display device 10 according to the embodiment of FIG. 27 may further include one or more auxiliary dam portions DAM3 and DAM4 disposed on the third insulating layer 125 in the hole periphery dam area HPDA and surrounding the periphery of the hole periphery encapsulation area HPENA, a hole periphery etching stop layer HPES disposed HPENA on the second insulating layer 124 in the hole periphery encapsulation area and covered with the third insulating layer 125, one or more first opening grooves OPGR1 disposed in the hole periphery encapsulation area HPENA, penetrating the third insulating layer 125, and sequentially surrounding the periphery of the hole area HLA, two or more groove guides GRGD disposed on the fourth insulating layer 126 in the hole periphery encapsulation area HPENA and overlapping the peripheral areas of the one or more first opening grooves OPGR1, respectively, and one or more encapsulation auxiliary grooves EAGR disposed between the two or more groove guides GRGD and penetrating the fourth insulating layer 126 and the fifth insulating layer 127.

The one or more auxiliary dam portions DAM3 and DAM4 may include a third dam portion DAM3 adjacent to the hole area HLA and a fourth dam portion DAM4 adjacent to the display area DA.

The third dam portion DAM may include a first dam layer DMI,31 disposed on the third insulating layer 125, which is the same layer as the fifth insulating layer 127, a second dam layer DML32 disposed on the first dam layer DML31, which is the same layer as the pixel defining layer 132, and a third dam layer DML33 disposed on the second dam layer DML32, which is the same layer as the spacer layer.

The fourth dam portion DAM may include a first dam layer DML41 disposed on the third insulating layer 125, which is the same layer as the pixel defining layer 132, and a second dam layer DMI,142 that is disposed on the first dam layer DML41, which is the same layer as the spacer layer.

Each of the one or more encapsulation auxiliary grooves EAGR may include a first auxiliary groove ASGR1 penetrating the fifth insulating layer 127, a second auxiliary groove ASGR2 penetrating the fourth insulating layer 126, and an undercut structure UC in which the edges of the groove guides GRGD protrude beyond the edges of the second auxiliary grooves ASGR2.

The hole periphery etching stop layer HPES prevents the second insulating layer 124 and inorganic layers disposed thereunder from being damaged by the one or more encapsulation auxiliary grooves EAGR.

The one or more first opening grooves OPGR1 penetrate the third insulating layer 125 to expose the hole periphery etching stop layer HPES.

The two or more groove guides GRGD allow the fourth insulating layer 126 to remain between the one or more encapsulation auxiliary grooves EAGR, thereby providing the position reference for the second auxiliary groove ASGR2.

In the light emitting element layer 130, the second common layer 135 and the cathode electrode 136 corresponding to the entire display area DA are disposed by a maskless deposition process, and thus may extend to the hole area HLA and the hole periphery encapsulation area HPENA.

In the hole area HLA, the second common layer 135 and the cathode electrode 136 may be removed by the through portion THM of the hole area HLA.

In the hole periphery encapsulation area HPENA, the second common layer 135 and the cathode electrode 136 may be separated by the undercut structure UC of each of the one or more encapsulation auxiliary grooves EAGR. Accordingly, the permeation path of oxygen or moisture through the second common layer 137 and the cathode electrode 138 disposed in the hole periphery area HPA is disconnected by the undercut structures of the encapsulation auxiliary grooves EAGR, which may delay the permeation of oxygen or moisture.

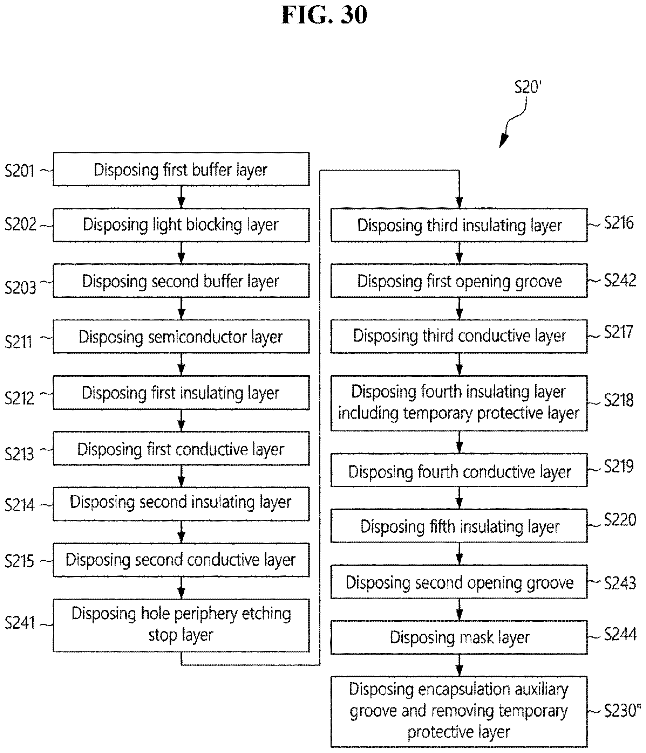

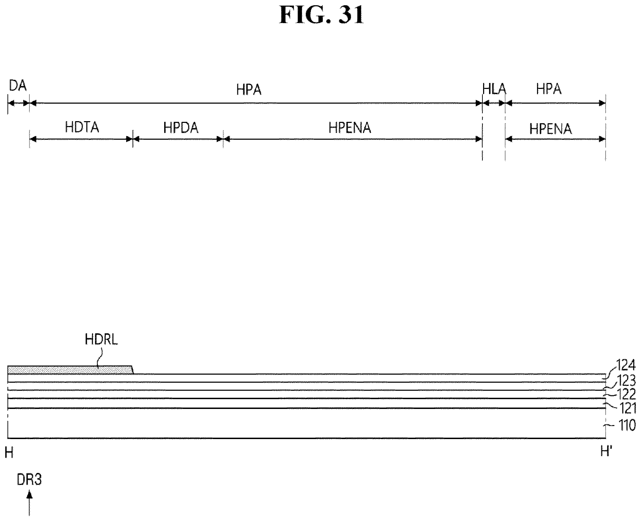

FIG. 30 is a flowchart showing steps of disposing the circuit layer of FIG. 12 according to the embodiment of FIG. 27. FIGS. 31, 32, 33, 34, 35, 36, 37, 38, 39, and 40 are process views illustrating some steps of FIGS. 12 and 30.

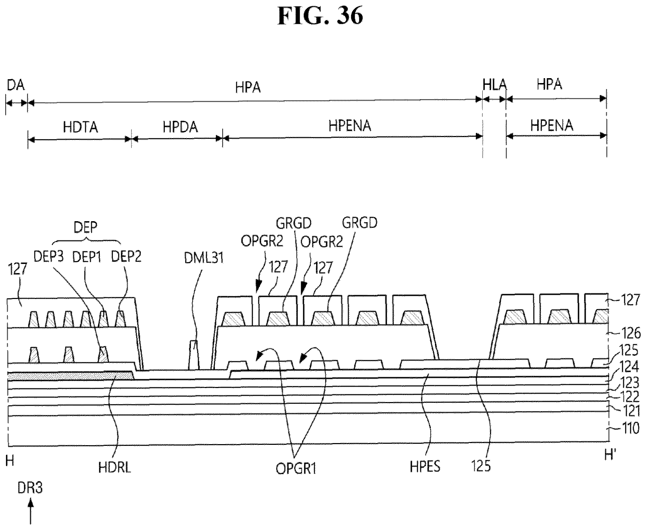

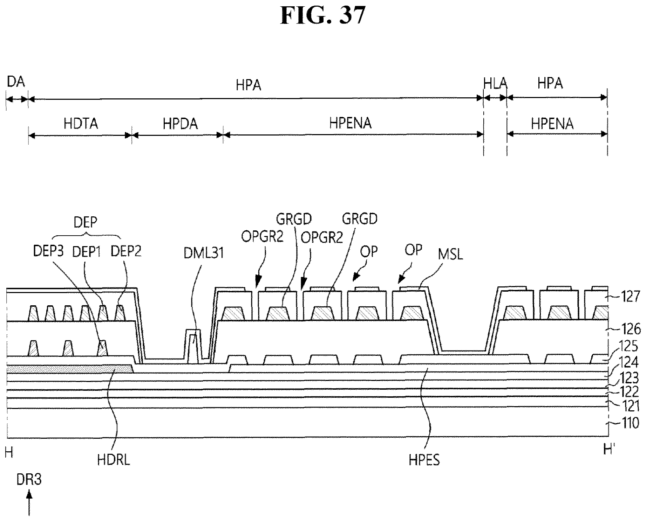

Referring to FIG. 30, that step S20' of disposing the circuit layer 120 in the manufacturing method of the display device 10 according to the embodiment of FIG. 27 is substantially the same as step S20 in the manufacturing method of the embodiment of FIG. 4 shown in FIG. 13 except that it further includes disposing the hole periphery etching stop layer HPES in the hole periphery encapsulation area HPENA on the second insulating layer 124 (step S241) before step S216 of disposing the third insulating layer 125, it further includes disposing the one or more first opening grooves OPGR1 corresponding to the hole periphery encapsulation area HPENA, sequentially surrounding the periphery of the hole area HLA, and penetrating the third insulating layer 125 (step S242) after step S216 of disposing the third insulating layer 125, and it further includes disposing second opening grooves OPGR2 (see FIG. 36) (step S243), disposing a mask layer MSL (see FIG. 37) (step S244), and disposing the encapsulation auxiliary grooves EAGR and removing the temporary protective layer PTL (step S230") after step S220 of disposing the fifth insulating layer 127, and also except that in step S219 of disposing the fourth conductive layer, the fourth conductive layer further includes the two or more groove guides GRGD disposed in the hole periphery encapsulation area HPENA and overlapping the peripheral areas of the one or more first opening grooves OPGR1, respectively, so that the redundant description will be omitted below.

Referring to FIG. 31, in step S215 of disposing the second conductive layer on the second insulating layer 124, the second conductive layer may include the first direction lines HDRL and the bypass portions thereof.

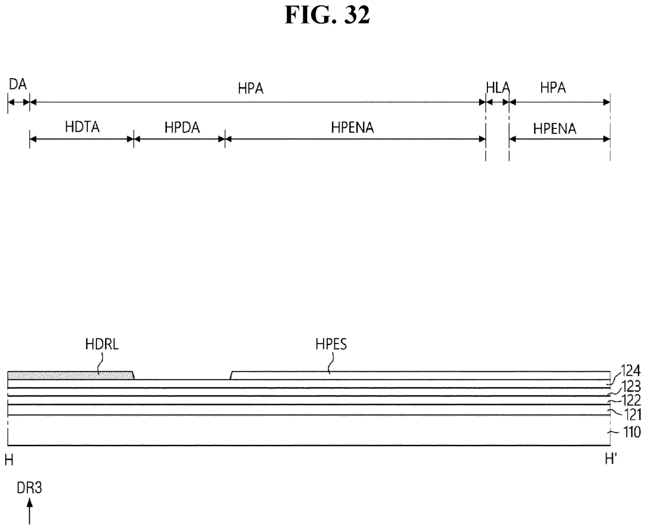

Referring to FIG. 32, in step S241 of disposing the hole periphery etching stop layer HPES on the second insulating layer 124, the hole periphery etching stop layer HPES may include a metal oxide material containing the same components as those of the mask layer MSL. In an embodiment, for example, the hole periphery etching stop layer HPES may include IGZO.

Due to the hole periphery etching stop layer HPES, the second insulating layer 124 made of an inorganic insulating material may be prevented from being damaged during step S230" of disposing the encapsulation auxiliary grooves EAGR.

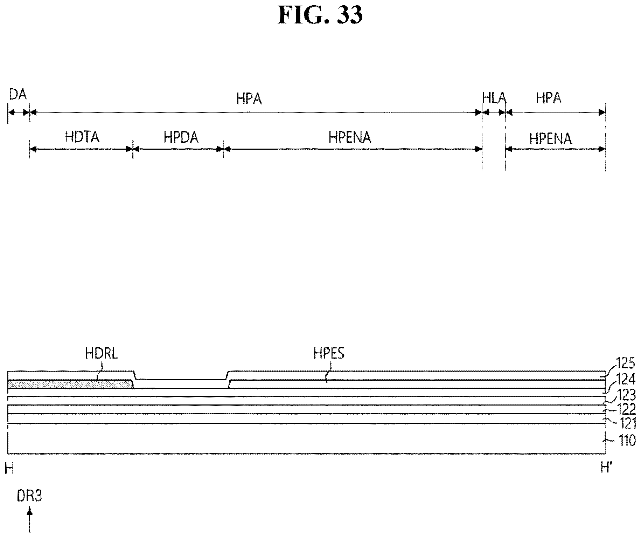

Referring to FIG. 33, in step S216 of disposing the third insulating layer 125 on the second insulating layer 124, the third insulating layer 125 may cover the second conductive layer HDRL and the hole periphery etching stop layer HPES.

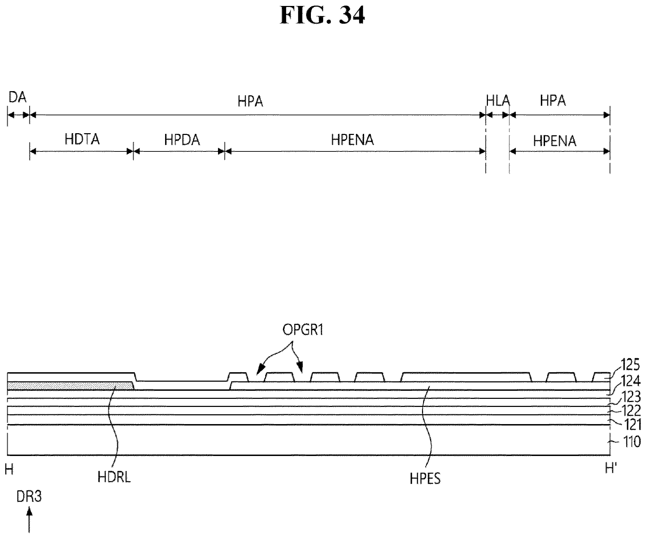

Referring to FIG. 34, in step S242 of disposing the one or more first opening grooves OPGR1, the third insulating layer 125 may be partially etched, so that the one or more first opening grooves OPGR1 sequentially surrounding the hole area HLA and penetrating the third insulating layer 125 may be disposed in the hole periphery encapsulation area HPENA.

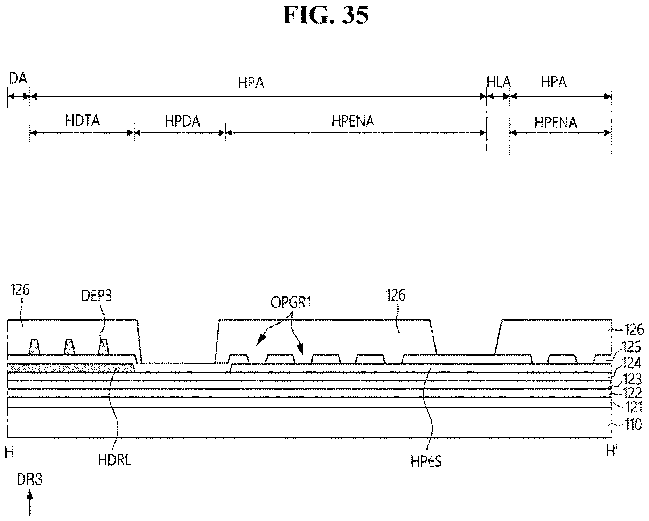

Referring to FIG. 35, in step S217 of disposing the third conductive layer, the third conductive layer may include some bypass portions among the bypass portions DEP disposed in the hole periphery bypass area HDTA. In an embodiment, for example, the third conductive layer may include the third bypass portion DEP3 electrically connected to each of the third hole intersection lines HINL3 that are some of the initialization voltage auxiliary lines VIAL.

Further, in step S218 of disposing the fourth insulating layer 126, a part of the fourth insulating layer 126 may be disposed in the hole periphery encapsulation area HPENA and the hole periphery bypass area HDTA in the hole periphery area HPA.

Further, as illustrated in FIG. 17, the fourth insulating layer 126 may further include the temporary protective layer TPL disposed in the junction area JNA of the non-display area NDA.

Referring to FIG. 36, in step S219 of disposing the fourth conductive layer, the fourth conductive layer on the fourth insulating layer 126 may further include the other bypass portions among the bypass portions DEP disposed in the hole periphery bypass area HDTA. In an embodiment, for example, the fourth conductive layer may further include the first bypass portion DEP1 electrically connected to each of the first hole intersection lines HINL1 that are some of the data lines DL, and the second bypass portion DEP2 electrically connected to each of the second hole intersection lines HINL2 that are some of the first power lines VDL.

In addition, the fourth conductive layer on the fourth insulating layer 126 may further include the two or more groove guides GRGD disposed in the hole periphery encapsulation area HPENA and overlapping the peripheral areas of the one or more first opening grooves OPGR1.

Next, in step S220 of disposing the fifth insulating layer 127, a part of the fifth insulating layer 127 may be disposed in the hole periphery encapsulation area HPENA and the hole periphery bypass area HDTA in the hole periphery area HPA. That is, the fifth insulating layer 127 may cover the bypass portions DEP of the hole periphery bypass area HDTA and the groove guides GRGD of the hole periphery encapsulation area HPENA.

In step S243 of disposing the one or more second opening grooves OPGR2, the fifth insulating layer 127 may be partially etched, so that the one or more second opening grooves OPGR2 overlapping the one or more first opening grooves OPGR1, respectively, may be disposed in the hole periphery encapsulation area HPENA.

Further, the first dam layer DML31 of the third dam portion DAM3 among the one or more auxiliary dam portions DAM3 and DAM4 may be provided as a part of the fifth insulating layer 127.

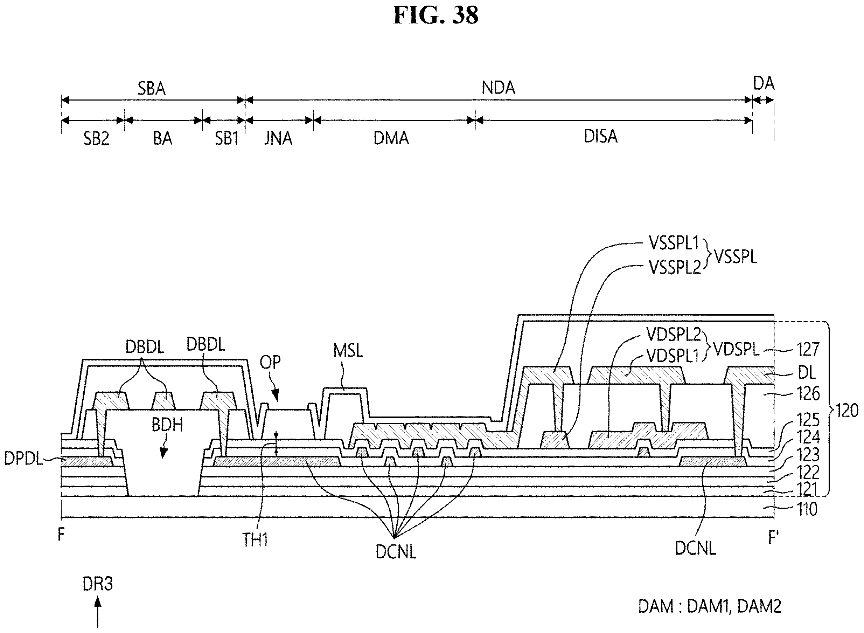

Referring to FIGS. 37 and 38, in step S244 of disposing the mask layer MSL, the mask layer MSL may include openings OP corresponding to the one or more second opening grooves OPGR2 and the temporary protective layer TPL, respectively.

The mask layer MSL may include a metal oxide material. In an embodiment, for example, the mask layer MSL may include IGZO.

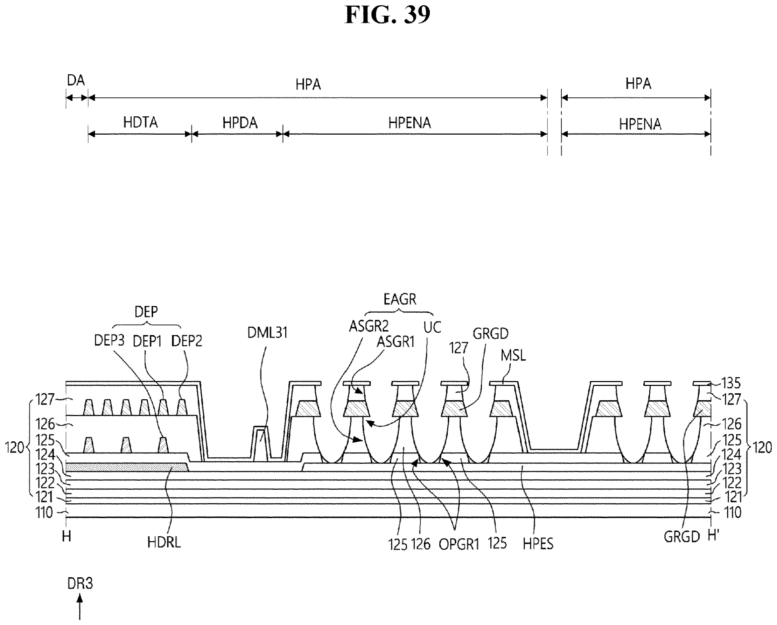

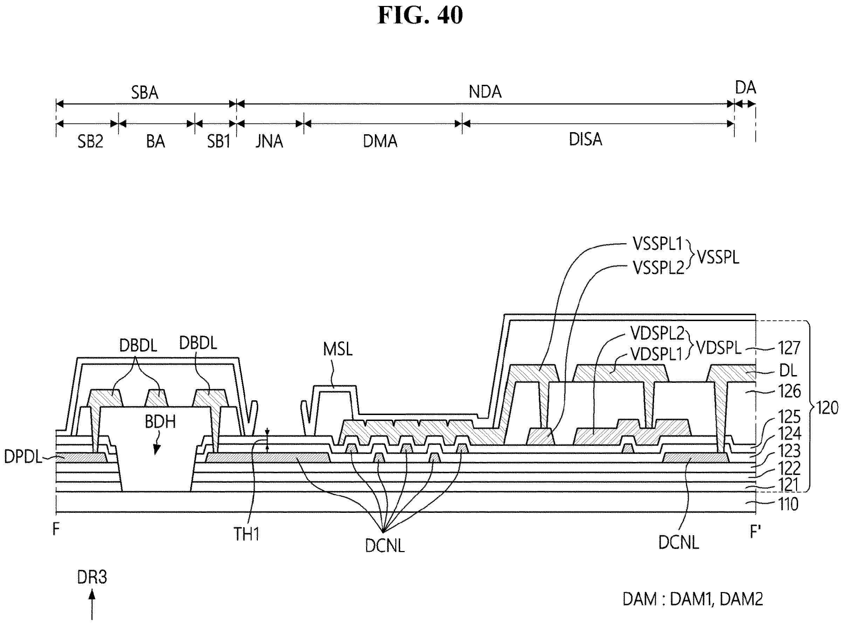

Referring to FIGS. 39 and 40, in step S230" of disposing the encapsulation auxiliary grooves EAGR and removing the temporary protective layer TPL, the fourth insulating layer 126 and the fifth insulating layer 127 may be partially etched based on the openings OP of the mask layer MSL, so that the one or more encapsulation auxiliary grooves EAGR, each including the first auxiliary groove ASGR1 penetrating the fifth insulating layer 127 and the second auxiliary groove ASGR2 penetrating the fourth insulating layer 126, may be disposed in the hole periphery encapsulation area HPENA.

Since the edges of the two or more groove guides GRGD protrude beyond the edges of the second auxiliary grooves ASGR2 of the encapsulation auxiliary grooves EAGR, the encapsulation auxiliary grooves EAGR may include the undercut structure UC.

Further, as shown in FIG. 40, since the mask layer MSL includes the opening OP corresponding to the temporary protective layer TPL, the removal of the temporary protective layer TPL may be performed at the time of disposing the encapsulation auxiliary grooves EAGR.

In this way, a separate mask process and a separate etching process for removing the temporary protective layer TPL may be excluded, which may be advantageous to simplify the manufacturing method.

Next, the mask layer MSL is removed, so that step S20 of disposing the circuit layer 120 may be completed.

In addition, as shown in FIG. 29, the manufacturing method of the display device according to the embodiment of FIG. 27 may further include disposing the through portion THM after step S60 of disposing of the polarization layer 160.

However, the effects of the present invention are not restricted to the one set forth herein. The above and other effects of the present disclosure will become more apparent to one of daily skill in the art to which the present disclosure pertains by referencing the claims.

## Claims

1. A display device (10) comprising:
a substrate (110) comprising a main region (MA) comprising a display area (DA) in which emission areas (EA) are arranged and a non-display area (NDA) disposed around the display area (DA), and a sub-region (SBA) protruding from one side of the main region (MA);
a circuit layer (120) disposed on the substrate (110);
a light emitting element layer (130) disposed on the circuit layer (120);
an encapsulation layer (140) disposed on the light emitting element layer (130); and
a polarization layer (160) disposed on the encapsulation layer (140) and overlapping the light emitting element layer (130),
wherein the non-display area (NDA) comprises:
a dam area (DMA) spaced apart from the display area (DA) and in which at least one dam portion (DAM) surrounding the display area (DA) is arranged; and
a junction area (JNA) surrounding the dam area (DMA),
wherein the circuit layer (120) comprises:
a semiconductor layer (ACT) disposed on the substrate (110);
a first insulating layer (123) disposed on the substrate (110), covering the semiconductor layer (ACT), and containing an inorganic insulating material;
a first conductive layer (G) disposed on the first insulating layer (123);
a second insulating layer (124) disposed on the first insulating layer (123), covering the first conductive layer (G), and containing the inorganic insulating material;
a second conductive layer (CAE) disposed on the second insulating layer (124);
a third insulating layer (125) disposed on the second conductive layer (CAE), covering the second conductive layer (CAE), and containing the inorganic insulating material;
a third conductive layer (S, D) disposed on the third insulating layer (125);
a fourth insulating layer (126) disposed on the third insulating layer (125), covering the third conductive layer (S, D), and containing an organic insulating material;
a fourth conductive layer (ANDE) disposed on the fourth insulating layer (126); and
a fifth insulating layer (127) disposed on the fourth insulating layer (126), covering the fourth conductive layer (ANDE), and containing the organic insulating material,
wherein in the junction area (JNA), the encapsulation layer (140) is disposed directly on the third insulating layer (125),
a thickness (TH2) of the third insulating layer (125) at a central point of the junction area (JNA) is substantially the same as a thickness (TH1) of the third insulating layer (125) in the display area (DA), and
the central point is measured with respect to a direction from the sub-region (SBA) to the main region (MA).

2. The display device (10) of claim 1, wherein the polarization layer (160) extends to the non-display area (NDA) and overlaps the junction area (JNA) of the non-display area (NDA).

3. The display device (10) of claim 2, wherein the sub-region (SBA) comprises a bending area (BA) which is bendable, a first sub-region (SB 1) disposed between a first side of the bending area (BA) and the main region (MA), and a second sub-region (SB2) connected to a second side of the bending area (BA) opposite to the first side,
the light emitting element layer (130) comprises light emitting elements (LE) corresponding to the emission areas (EA), respectively,
the circuit layer (120) further comprises:
pixel drivers (PXD) corresponding to the emission areas (EA) and electrically connected to the light emitting elements (LE) of the light emitting element layer (130), respectively;
data lines (DL) for transmitting a data signal to the pixel drivers (PXD); and
data connection lines (DCNL) disposed in the non-display area (NDA) electrically connected to the data lines (DL), respectively, and extending to the first sub-region (SB1),
the fourth conductive layer (ANDE) comprises the data lines (DL),
the first conductive layer (G) comprises some of the data connection lines (DCNL),
the second conductive layer (CAE) comprises remaining others of the data connection lines (DCNL), and
the polarization layer (160) overlaps the data connection lines (DCNL) in the non-display area (NDA).

4. The display device (10) of claim 3, wherein each of the pixel drivers (PXD) comprises two or more transistors (DT, ST1-ST6) and at least one capacitor (PC1),
The semiconductor layer (ACT) comprises active layers of the transistors (DT, ST1-ST6),
the first conductive layer (G) further comprises gate electrodes of the transistors (DT, ST1-ST6),
the second conductive layer (CAE) further comprises a first capacitor (PC1) electrode of the capacitor (PC1),
the third conductive layer (S, D) comprises source electrodes of the transistors (DT, ST1-ST6) and drain electrodes of the transistors (DT, ST1-ST6), and
the fourth conductive layer (ANDE) further comprises anode connection electrodes corresponding to the emission areas (EA), respectively.

5. The display device (10) of at least one of claims 1 to 4, wherein the encapsulation layer (140) comprises:
a first encapsulation layer (140) disposed in the main region (MA), covering the light emitting element layer (130) and the at least one dam portion (DAM), and containing the inorganic insulating material;
a second encapsulation layer (142) disposed on the first encapsulation layer (140), overlapping the light emitting element layer (130), and containing the organic insulating material; and
a third encapsulation layer (143) covering the second encapsulation layer (142) and containing the inorganic insulating material,
wherein the second encapsulation layer (142) is disposed in an area surrounded by the at least one dam portion (DAM) in the main region (MA),
the first encapsulation layer (140) is in contact with the third insulating layer (125) in the junction area (JNA), and
the third encapsulation layer (143) is in contact with the first encapsulation layer (140) in the junction area (JNA).

6. The display device (10) of at least one of claims 1 to 5, wherein the light emitting element layer (130) comprises:
anode electrodes (131) disposed on the fifth insulating layer (127) of the circuit layer (120) and corresponding to the emission areas (EA), respectively;
a pixel defining layer (132) disposed on the fifth insulating layer (127) of the circuit layer (120), corresponding to a non-emission area (NEA) which is a separation area between the emission areas (EA), and covering an edge of each of the anode electrodes (131);
a spacer layer disposed on a part of the pixel defining layer (132);
first common layers (133) disposed on the anode electrodes (131), respectively;
light emitting layers (134) disposed on the first common layers (133), respectively;
a second common layer (135) disposed on the pixel defining layer (132), the spacer layer, and the light emitting layers (134); and
a cathode electrode (136) disposed on the second common layer (135),
wherein each of the light emitting elements (LE) comprises a structure in which a corresponding first common layer (133), a corresponding light emitting layer (134), and the second common layer (135) are disposed between a corresponding anode electrode and the cathode electrode (136) facing each other.

7. The display device (10) of claim 3 and 6, further comprising:
data bending lines (DBDL) disposed in the bending area (BA), electrically connected to the data connection lines (DCNL), respectively, and extending to the second sub-region (SB2);
a bending hole (BDH) defined in the bending area (BA) and penetrating the first insulating layer (123), the second insulating layer (124), and the third insulating layer (125); and
a bank (BNK) covering the bending hole (BDH) and extending to the first sub-region (SB1);
wherein the bank (BNK) comprises:
a first bank layer (BNL1) which is a part of the fourth insulating layer (126) and covers the bending hole (BDH);
a second bank layer (BNL2) which is a part of the fifth insulating layer (127) and covers the first bank layer (BNL1);
a third bank layer (BNL3), which is a same layer as the pixel defining layer (132) and disposed on the second bank layer (BNL2); and
a fourth bank layer (BNL4), which is a same layer as the spacer layer and disposed on the third bank layer (BNL3);
wherein the fourth conductive layer (ANDE) further comprises the data bending lines (DBDL),
the data bending lines (DBDL) are disposed on the first bank layer (BNL1) and covered with the second bank layer (BNL2),
each of the at least one dam portion (DAM) comprises a structure in which two or more dam layers are stacked,
each of the two or more dam layers is a same layer as any one of the fourth insulating layer (126), the fifth insulating layer (127), the pixel defining layer (132), and the spacer layer, and
the polarization layer (160) extends to the first sub-region (SB 1) and overlaps a part of the bank (BNK).

8. The display device (10) of claim 6 or 7, wherein the display device (10) defines a through portion (THM) therein corresponding to a hole area (HLA) surrounded by the main region (MA) and penetrating the substrate (110), the circuit layer (120), the light emitting element layer (130), the encapsulation layer (140), and the polarization layer (160),
wherein a hole periphery area (HPA) between the hole area (HLA) and the main region (MA) comprises:
a hole periphery encapsulation area (HPENA) disposed around the hole area (HLA);
a hole periphery dam area (HPDA) disposed around the hole periphery encapsulation area (HPENA); and
a hole periphery bypass area (HDTA) disposed between the hole periphery dam area (HPDA) and the main region (MA),
the display device (10) further comprising:
at least one auxiliary dam portion (DAM3, DAM4) disposed on the third insulating layer (125) in the hole periphery dam area (HPDA) and surrounding a periphery of the hole periphery encapsulation area (HPENA);
a hole periphery etching stop layer (HPES) disposed on the second insulating layer (124) in the hole periphery encapsulation area (HPENA) and covered with the third insulating layer (125);
one or more first opening grooves (OPGR1) defined in the hole periphery encapsulation area (HPENA), penetrating the third insulating layer (125), and sequentially surrounding a periphery of the hole area (HLA);
two or more groove guides (GRGD) disposed on the fourth insulating layer (126) in the hole periphery encapsulation area (HPENA) and overlapping peripheral areas of the one or more first opening grooves (OPGR1), respectively; and
one or more encapsulation auxiliary grooves (EAGR) defined between the two or more groove guides (GRGD) and penetrating the fourth insulating layer (126) and the fifth insulating layer (127),
wherein each of the one or more encapsulation auxiliary grooves (EAGR) comprises a first auxiliary groove (ASGR1) penetrating the fifth insulating layer (127), a second auxiliary groove (ASGR2) penetrating the fourth insulating layer (126), and an undercut structure (UC) in which edges of the two or more groove guides (GRGD) protrude beyond edges of the second auxiliary grooves (ASGR2) of the one or more encapsulation auxiliary grooves (EAGR), and
the second common layer (135) and the cathode electrode (136) each are discontinuous by the undercut structure (UC) of each of the one or more encapsulation auxiliary grooves (EAGR).

9. A method for manufacturing a display device (10), comprising:
providing a substrate (110) comprising a main region (MA) comprising a display area (DA) in which emission areas (EA) are arranged and a non-display area (NDA) disposed around the display area (DA), and a sub-region (SBA) protruding from one side of the main region (MA); and
disposing a circuit layer (120) comprising pixel drivers (PXD) corresponding to the emission areas (EA), respectively, on the substrate (110),
wherein the disposing of the circuit layer (120) comprises:
disposing a semiconductor layer (ACT) on the substrate (110);
disposing a first insulating layer (123) covering the semiconductor layer (ACT) on the substrate (110);
disposing a first conductive layer (G) on the first insulating layer (123);
disposing a second insulating layer (124) covering the first conductive layer (G) on the first insulating layer (123);
disposing a second conductive layer (CAE) on the second insulating layer (124);
disposing a third insulating layer (125) covering the second conductive layer (CAE) on the second insulating layer (124);
disposing a third conductive layer (S, D) on the third insulating layer (125);
disposing a fourth insulating layer (126) covering the third conductive layer (S, D) on the third insulating layer (125);
disposing a fourth conductive layer (ANDE) on the fourth insulating layer (126); and
disposing a fifth insulating layer (127) covering the fourth conductive layer (ANDE) on the fourth insulating layer (126),
wherein the non-display area (NDA) comprises a dam area (DMA) spaced apart from the display area (DA) and in which at least one dam portion (DAM) surrounding the display area (DA) is arranged, and a junction area (JNA) surrounding the dam area (DMA),
in the disposing of the fourth insulating layer (126), the fourth insulating layer (126) comprises a first planarization layer disposed in the display area (DA), and a temporary protective layer (TPL) disposed in at least a part of the junction area (JNA) and spaced apart from the dam area (DMA) and the sub-region (SBA),
in the disposing of the fifth insulating layer (127), the fifth insulating layer (127) comprises a second planarization layer covering the first planarization layer, and
the disposing of the circuit layer (120) further comprises removing the temporary protective layer (TPL) after the disposing of the fourth conductive layer (ANDE).

10. The method of claim 9, wherein the removing of the temporary protective layer (TPL) is performed before the disposing of the fifth insulating layer (127).

11. The method of claim 9, wherein the removing of the temporary protective layer (TPL) is performed after the disposing of the fifth insulating layer (127).

12. The method of at least one of claims 9 to 11, wherein the sub-region (SBA) comprises a bending area (BA) which is bendable, a first sub-region (SB1) disposed between a first side of the bending area (BA) and the main region (MA), and a second sub-region (SB2) connected to a second side of the bending area (BA) opposite to the first side, and
the disposing of the circuit layer (120) further comprises, before the disposing of the third conductive layer (S, D), forming a bending hole (BDH) corresponding to the bending area (BA) and penetrating the first insulating layer (123), the second insulating layer (124), and the third insulating layer (125).

13. The method of at least one of claims 9 to 12, further comprising:
disposing a light emitting element layer (130) on the circuit layer (120);
disposing an encapsulation layer (140) on the light emitting element layer (130);
disposing a touch sensor layer (150) on the encapsulation layer (140); and
disposing a polarization layer (160) overlapping the light emitting element layer (130) on the touch sensor layer (150),
wherein in the disposing of the light emitting element layer (130), the light emitting element layer (130) comprises:
anode electrodes (131) disposed on the fifth insulating layer (127) of the circuit layer (120) and corresponding to the emission areas (EA), respectively;
a pixel defining layer (132) disposed on the fifth insulating layer (127) of the circuit layer (120), corresponding to a non-emission area (NEA) which is a separation area between the emission areas (EA), and covering an edge of each of the anode electrodes (131);
a spacer layer disposed on a part of the pixel defining layer (132);
first common layers (133) disposed on the anode electrodes (131), respectively;
light emitting layers (134) disposed on the first common layers (133), respectively;
a second common layer (135) disposed on the pixel defining layer (132), the spacer layer and the light emitting layers (134); and
a cathode electrode (136) disposed on the second common layer (135),
wherein each of the light emitting elements (LE) comprises a structure in which a corresponding first common layer (133), a corresponding light emitting layer (134), and the second common layer (135) are disposed between a corresponding anode electrode and the cathode electrode (136) facing each other.

14. The method of at least one of claims 9 to 13, wherein the circuit layer (120) comprises:
data lines (DL) for transmitting a data signal to the pixel drivers (PXD); and
data connection lines (DCNL) disposed in the non-display area (NDA), electrically connected to the data lines (DL), respectively, and extending to the first sub-region (SB 1),
each of the pixel drivers (PXD) of the circuit layer (120) comprises two or more transistors (DT, ST1-ST6) and at least one capacitor (PC1),
in the disposing of the semiconductor layer (ACT), the semiconductor layer (ACT) comprises active layers of the transistors (DT, ST1-ST6),
in the disposing of the first conductive layer (G), the first conductive layer (G) further comprises gate electrodes of the transistors (DT, ST1-ST6), and some of the data connection lines (DCNL),
in the disposing of the second conductive layer (CAE), the second conductive layer (CAE) further comprises a first capacitor (PC1) electrode of the capacitor (PC1), and remaining others of the data connection lines (DCNL),
in the disposing of the third conductive layer (S, D), the third conductive layer (S, D) comprises source electrodes of the transistors (DT, ST1-ST6) and drain electrodes of the transistors (DT, ST1-ST6), and
in the disposing of the fourth conductive layer (ANDE), the fourth conductive layer (ANDE) further comprises anode connection electrodes corresponding to the emission areas (EA), respectively.

15. The method of claim 14, wherein in the disposing of the fourth insulating layer (126), the temporary protective layer (TPL) overlaps a part of the data connection lines (DCNL).

16. The method of at least one of claims 9 to 15, wherein in the disposing of the encapsulation layer (140), the encapsulation layer (140) comprises:
a first encapsulation layer (141) disposed in the main region (MA), covering the light emitting element layer (130) and the at least one dam portion (DAM), and containing the inorganic insulating material;
a second encapsulation layer (142) disposed on the first encapsulation layer (141), overlapping the light emitting element layer (130), and containing the organic insulating material; and
a third encapsulation layer (143) covering the second encapsulation layer (142) and containing the inorganic insulating material,
wherein the second encapsulation layer (142) is disposed in an area surrounded by the at least one dam portion (DAM) in the main region (MA),
the first encapsulation layer (141) is in contact with the third insulating layer (125) in the junction area (JNA), and
the third encapsulation layer (143) is in contact with the first encapsulation layer (141) in the junction area (JNA).

17. The method of at least one of claims 14 to 16, wherein in the disposing of the polarization layer (160), the polarization layer (160) extends to the non-display area (NDA) and further overlaps the data connection lines (DCNL) of the non-display area (NDA).

18. The method of at least one of claims 13 to 17, wherein in the disposing of the fourth insulating layer (126), the fourth insulating layer (126) further comprises a first bank layer (BNL1) covering the bending hole (BDH) of the bending area (BA), extending to the first sub-region (SB1), and spaced apart from the temporary protective layer (TPL),
in the disposing of the fourth conductive layer (ANDE), the fourth conductive layer (ANDE) further comprises data bending lines (DBDL) disposed in the bending area (BA), electrically connected to the data connection lines (DCNL), respectively, and extending to the second sub-region (SBA),
in the disposing of the fifth insulating layer (127), the fifth insulating layer (127) further comprises a second bank layer (BNL2) covering the first bank layer (BNL1) and the data bending lines (DBDL),
in the disposing of the light emitting element layer (130), a third bank layer (BNL3) which is a same layer as the pixel defining layer (132) and disposed on the second bank layer (BNL2), and a fourth bank layer (BNL4) which is a same layer as the spacer layer and disposed on the third bank layer (BNL3) are provided.

19. The method of at least one of claims 13 to 18, wherein each of the at least one dam portion (DAM) comprises a structure in which two or more dam layers are stacked, and
each of the two or more dam layers is a same layer as any one of the fourth insulating layer (126), the fifth insulating layer (127), the pixel defining layer (132), and the spacer layer.

20. The method of at least one of claims 13 to 19, wherein in the providing of the substrate (110), the substrate (110) further comprises a hole area (HLA) surrounded by the main region (MA), and a hole periphery area (HPA) disposed between the main region (MA) and the hole area (HLA), and
the method further comprising, after the disposing of the polarization layer (160), forming a through portion (THM) corresponding to the hole area (HLA), and penetrating the substrate (110), the circuit layer (120), the light emitting element layer (130), the encapsulation layer (140), and the polarization layer (160).

21. The method of claim 20, wherein the hole periphery area (HPA) comprises:
a hole periphery encapsulation area (HPENA) disposed around the hole area (HLA);
a hole periphery dam area (HPDA) disposed around the hole periphery encapsulation area (HPENA); and
a hole periphery bypass area (HDTA) disposed between the hole periphery dam area (HPDA) and the main region (MA),
wherein the pixel defining layer (132) and the spacer layer are spaced apart from the hole periphery bypass area (HDTA),
in the hole periphery dam area (HPDA), at least one auxiliary dam portion (DAM3, DAM4) surrounding a periphery of the hole periphery encapsulation area (HPENA) is disposed on the third insulating layer (125), and
in the hole periphery encapsulation area (HPENA), one or more encapsulation auxiliary grooves (EAGR) surrounding a periphery of the hole area (HLA) and penetrating the fourth insulating layer (126) and the fifth insulating layer (127) are arranged.

22. The method of claim 21, wherein the disposing of the circuit layer (120) further comprises:
Before the disposing of the third insulating layer (125), disposing a hole periphery etching stop layer (HPES) on the second insulating layer (124) in the hole periphery encapsulation area (HPENA), and
after the disposing of the third insulating layer (125), forming one or more first opening grooves (OPGR1) corresponding to the hole periphery encapsulation area (HPENA), sequentially surrounding a periphery of the hole area (HLA), and penetrating the third insulating layer (125),
wherein in the disposing of the fourth conductive layer (ANDE), the fourth conductive layer (ANDE) further comprises two or more groove guides (GRGD) disposed in the hole periphery encapsulation area (HPENA) and overlapping peripheral areas of the one or more first opening grooves (OPGR1), respectively,
the method further comprising: after the disposing of the fifth insulating layer (127),
forming one or more second opening grooves (OPGR1) overlapping the one or more first opening grooves (OPGR1), respectively, and penetrating the fifth insulating layer (127);
disposing a mask layer (MSL) defining openings (OP) corresponding to the one or more second opening grooves (OPGR1) and the temporary protective layer (TPL), respectively, on the fifth insulating layer (127); and
forming the one or more encapsulation auxiliary grooves (EAGR), and removing the temporary protective layer (TPL) by partially etching the fourth insulating layer and the fifth insulating layer (127) using the two or more groove guides (GRGD) and the mask layer (MSL) as masks.

23. The method of claim 21 or 22, wherein in the disposing of the encapsulation auxiliary grooves (EAGR), each of the encapsulation auxiliary grooves (EAGR) comprises a first auxiliary groove (ASGR1) penetrating the fifth insulating layer (127), a second auxiliary groove (ASGR2) penetrating the fourth insulating layer, and an undercut structure (UC) in which edges of the two or more groove guides (GRGD) protrude beyond edges of the second auxiliary grooves (ASGR2) of the one or more encapsulation auxiliary grooves (EAGR), and
in the disposing of the light emitting element layer (130), the second common layer (135) and the cathode electrode (136) each are discontinuous by the undercut structure (UC) of each of the one or more encapsulation auxiliary grooves (EAGR).
